(19) Europäisches Patentamt
European Patent Office
Office européen des brevets

(11) Publication number : **0 373 952 B1**

(12) # EUROPEAN PATENT SPECIFICATION

(45) Date of publication of patent specification : **08.02.95 Bulletin 95/06**

(51) Int. Cl.$^6$ : **G03F 7/038,** G03F 7/075

(21) Application number : **89313131.8**

(22) Date of filing : **15.12.89**

(54) **Photosensitive resin composition and photosensitive element using the same.**

(30) Priority : **16.12.88 JP 318813/88**
**16.12.88 JP 318814/88**
**19.04.89 JP 99168/89**
**26.05.89 JP 134383/89**

(43) Date of publication of application : **20.06.90 Bulletin 90/25**

(45) Publication of the grant of the patent : **08.02.95 Bulletin 95/06**

(84) Designated Contracting States : **CH DE FR GB LI NL SE**

(56) References cited :
**EP-A- 0 157 929**
**EP-A- 0 157 930**
**EP-A- 0 203 372**
**EP-A- 0 262 446**
**DE-A- 3 424 216**
**US-A- 4 578 328**

(73) Proprietor : **Hitachi Chemical Co., Ltd.**
**1-1, Nishishinjuku 2-chome**
**Shinjuku-ku, Tokyo 160 (JP)**

(72) Inventor : **Satoh, Kuniaki**
**16-9-2, Takasuzucho-1-chome**
**Hitachi-shi (JP)**
Inventor : **Kojima, Yasunori**
**Yamasakiryo**
**2-9, Higashicho-4-chome**
**Hitachi-shi (JP)**
Inventor : **Tachiki, Shigeo**
**31-5, Kawajiricho-6-chome**
**Hitachi-shi (JP)**
Inventor : **Kikuchi, Tohru**
**5-D-304, Nakanarusawacho-1-chome**
**Hitachi-shi (JP)**
Inventor : **Ishimaru, Toshiaki**
**14-6, Mikanoharacho-1-chome**
**Hitachi-shi (JP)**
Inventor : **Hayashi, Nobuyuki**
**17-1, Suwacho-5-chome**
**Hitachi-shi (JP)**
Inventor : **Kojima, Mitsumasa**
**16-9, Takasuzucho-1-chome**
**Hitachi-shi (JP)**

(74) Representative : **Cresswell, Thomas Anthony et al**
**J.A. KEMP & CO.**
**14 South Square**
**Gray's Inn**
**London WC1R 5LX (GB)**

EP 0 373 952 B1

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to a photosensitive resin composition and a photosensitive element using the same which are excellent in light-transmitting properties and solubility, can be made into a final cured film having excellent heat resistance, adhesive properties, flexibility, electrical properties and mechanical properties by heat treatment, can be formed into a thick film, have a high photosensitivity also when used in the form of a thick film, and are suitable for use in interlaminar insulating films or surface protective films of multilayer circuit board or semiconductor element, pastes for color filter, etc.

Heat-resistant polymers represented by polyimides are excellent in heat resistance, electrical properties and mechanical properties and hence have heretofore been used in interlaminar insulating films or surface protective films (e.g. $\alpha$-ray shielding film, passivation film, buffer coat film, etc.) in semiconductor element. They have been widely used also in the field of circuit boards, for example, in resists for forming a circuit pattern on a substrate, or interlaminar insulating films of multilayer circuit board.

In the semiconductor industry, inorganic materials have heretofore been used in interlaminar insulating films and surface protective films, but in recent years, organic materials excellent in heat resistance, such as polyimides, have been used by taking advantage of their characteristics.

A pattern of a surface protective film or interlaminar insulating film of a semiconductor element or multilayer circuit board is formed through troublesome and various steps such as formation of a resist material into a film on the surface of a substrate, exposure of a predetermined portion to light, removal of an unnecessary portion by etching and the like, cleaning of the substrate surface, etc. Therefore, it is desirable to develop a heat-resistant photosensitive material which is such that after forming a pattern by exposure and development, a resist material in a necessary portion remains and can be used as it is as an insulating material.

As such a material, there have been proposed, for example, heat-resistant photosensitive materials obtained by using a photosensitive polyimide, a cyclized polybutadiene or the like as a base polymer. Photosensitive polyimides are particularly noted because of, for example, their excellent heat resistance and easy removal of their impurities.

As such a polyimide, for example, Japanese Patent Publication No. 49-17374 has proposed a system comprising a polyimide precursor and a dichromate, at first. But although this material is advantageous in that it has a practical photosensitivity and a high film-forming ability, it is disadvantageous, for example, in that it is poor in storage stability and that chromium ions remain in polyimide. Therefore, it has not been put into practical use.

Japanese Patent Publication No. 55-100143 and Japanese Patent Appln. Kokai (Laid-Open) No. 60-100143 have proposed processes in which a photosensitive group is given by using an ester linkage or an isocyanate compound, respectively. But the material obtained by the former process has low adhesive properties to a substrate and hence tends to be peeled off, while the material obtained by the latter process has low light-transmitting properties and is difficult to form into a thick film.

This invention was made in consideration of such problems of prior art and provides a photosensitive resin composition and a photosensitive element using the same which are excellent in light-transmitting properties and solubility, can be made into a final cured film having excellent heat resistance, adhesive properties, flexibility, electrical properties and mechanical properties by heat treatment, can be formed into a thick film, and have a high sensitivity also when used in the form of a thick film.

This invention provides a negative-type photosensitive resin composition comprising

(A) a photoinitiator;

(B) a polymer obtainable by reacting an isocyanate compound having at least one ethylenically. unsaturated group with a polymer containing a repeating unit of formula (1)

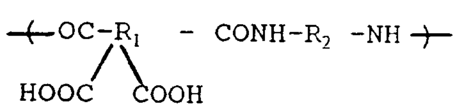

(1)

wherein $R_1$ is a silicon-containing tetravalent organic group of formula (VI)

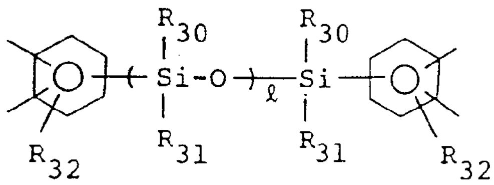

(VI)

in which $R_{30}$ and $R_{31}$ are the same or different and each is a monovalent hydrocarbon group; $R_{32}$ is hydrogen or a monovalent organic group; $\ell$ is zero or an integer of 1 to 20; and $R_2$ is a divalent organic group; (C) one or more polymerisable unsaturated compounds.

This invention further provides a photosensitive element obtained by laminating said photosensitive resin composition on a substrate.

Preferably in formula (1) $R^2$ is a divalent aromatic group or a siloxane group-containing divalent organic group.

Additionally in formula (1), preferably at least one of $R_1$ and $R_2$ contains at least one fluorine atom.

In formula (1), $R_2$ is a preferably silicon atom-containing divalent organic group of formula (VII)

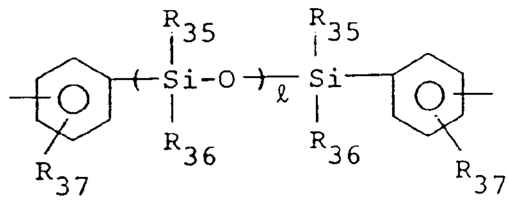

(VII)

wherein $R_{35}$ and $R_{36}$ are the same or different and each is a monovalent hydrocarbon group, $R_{37}$ is hydrogen or a monovalent organic group; and $\ell$ is zero or an integer of 1 to 20.

Alternatively in formula (1), $R_2$ may be a fluorine atom-containing divalent organic group of formula (IX)

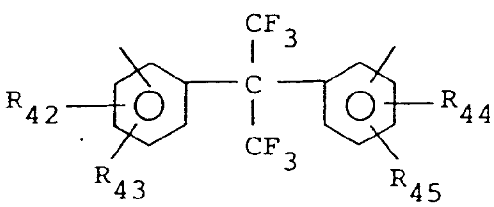

(IX)

in which $R_{42}$, $R_{43}$, $R_{44}$ and $R_{45}$ are the same or different and each is hydrogen or alkyl or $R_2$ is a fluorine atom-containing divalent organic group of formula (X)

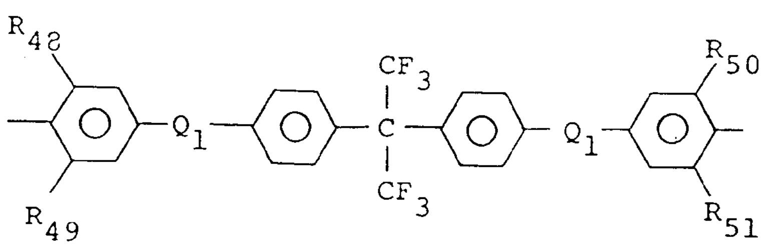

(X)

in which $Q_1$ is oxygen or sulphur and $R_{48}$, $R_{49}$, $R_{50}$ and $R_{51}$, are the same or different and each is hydrogen or alkyl.

The polymer (B) is suitably obtainable by reacting a polymer containing a repeating unit of formula (XI) and a repeating unit of formula (XII)

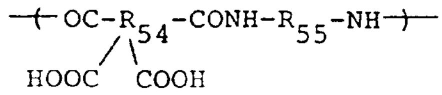

(XI)

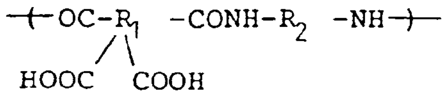

(XII)

wherein $R_{54}$ is a tetravalent aromatic group which is the same as or different from $R_1$ and $R_{55}$ is a divalent organic group which is the same as or different from $R_2$ with an isocyanate compound of formula (XIV)

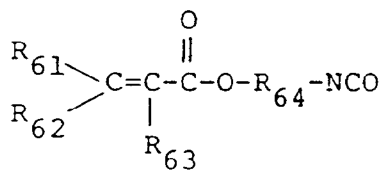

(XIV)

wherein $R_{61}$, $R_{62}$ and $R_{63}$ are the same or different and each is hydrogen or methyl and $R_{64}$ is a divalent hydrocarbon group or with an isocyanate compound of formula (XV)

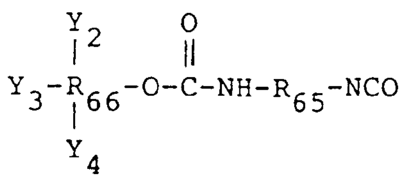

(XV)

wherein $R_{65}$ is a divalent hydrocarbon group, $R_{66}$ is a tetravalent organic group, and $Y_2$, $Y_3$ and $Y_4$ are the same or different and each is hydrogen or a monovalent organic group having an ethylenically unsaturated group, at least one of $Y_2$, $Y_3$ and $Y_4$ being a monovalent organic group having an ethylenically unsaturated group.

Alternatively the polymer (B) may be obtainable by reacting a polymer containing a repeating unit of formula (XVI) and a repeating unit of formula (XVII)

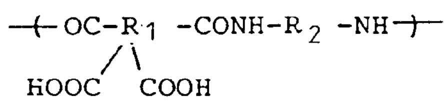

(XVI)

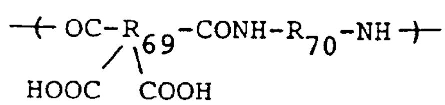

(XVII)

wherein $R_{69}$ is a tetravalent organic group and is the same or different from $R_1$ and $R_{70}$ is a silicon atom-containing divalent organic group of formula (XVIII)

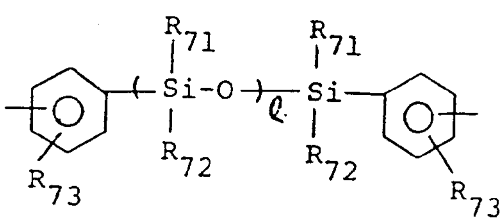

(XVIII)

wherein $R_{71}$ and $R_{72}$ are the same or different and each is a monovalent hydrocarbon group, $R_{73}$ is hydrogen

or a monovalent organic group and $\ell$ is zero or an integer of 1 to 20, with an isocyanate compound of formula (XIV) or (XV) as defined above.

The polymer (B) used in this invention is obtained, for example, by reacting an isocyanato compound having at least one ethylenically unsaturated group with a polymer containing a repeating unit of the general formula:

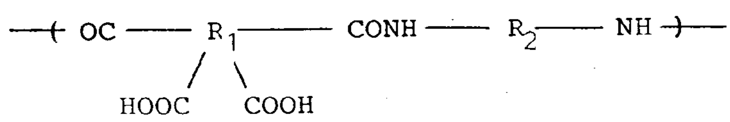

wherein $R_1$ is a silicon-containing tetravalent organic group of formula (VI)

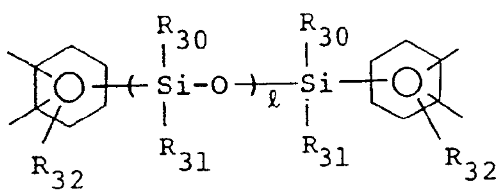

(VI)

in which $R_{30}$ and $R_{31}$ are the same or different and each is a monovalent hydrocarbon group; $R_{32}$ is hydrogen or a monovalent organic group; $\ell$ is zero or an integer of 1 to 20; and $R_2$ is a divalent organic group.

The reaction of the isocyanato compound having at least one ethylenically unsaturated group with the polymer comprising recurring units of the general formula (1) is carried out in an inert organic solvent at a temperature of preferably 0° to 100°C, more preferably 20° to 70°C.

As the organic solvent used in the reaction, polar solvents capable of completely dissolving the polymer (B) can be used. There can be exemplified N-methyl-2-pyrrolidone, N,N-dimethylacetamide, N,N-dimethylformamide, dimethyl sulfoxide, tetramethylurea, hexamethylphosphoric triamide, γ-butyrolactone, N,N-dimethylpropylene urea, N,N-dimethylethylene urea, etc. These polar solvents can be used singly or in combination of two or more thereof.

In addition to these polar solvents, there can also be used common organic solvents such as ketones, esters, lactones, ethers, halogenated hydrocarbons, and hydrocarbons, for example, acetone, methyl ethyl ketone, methyl isobutyl ketone, cyclohexanone, methyl acetate, ethyl acetate, butyl acetate, diethyl oxalate, diethyl malonate, γ-butyrolactone, diethyl ether, ethylene glycol dimethyl ether, diethylene glycol dimethyl ether, tetrahydrofuran, dichloromethane, 1,2-dichloroethane, 1,4-dichlorobutane, trichloroethane, chlorobenzene, o-dichlorobenzene, hexane, heptane, octane, benzene, toluene, xylene, etc.

In order to dissolve the polymer (B) completely, these common organic solvents are used preferably in admixture with the above polar solvents. The amount of these organic solvents used is preferably 90 to 1,900 parts by weight, more preferably 150 to 500 parts by weight per 100 parts by weight of the polymer (B).

As to the proportion of the isocyanato compound having at least one ethylenically unsaturated group to the polymer containing the repeating unit of the general formula (1), the isocyanato compound is usually reacted with said polymer in an amount of preferably 0.01 to 0.9 equivalent weight, more preferably 0.1 to 0.8 equivalent weight, most preferably 0.2 to 0.5 equivalent weight, per equivalent weight of the carboxyl group in said polymer from the viewpoint of the sensitivity of the photosensitive resin composition and the heat resitance of a final cured film.

The reaction of the isocyanato compound having one or more ethylenically unsaturated groups with the polymer containing the repeating unit of the general formula (1) can be facilitated using, for example, an amine such as triethylamine, 1,4-diazobicyclo[2,2,2]octane, etc., or a tin compound such as dibutyltin dilaurate, dibutyltin diacetate, etc., like a catalyst. These compounds can be used usually in an amount of about 0.01 to about 5% by weight based on the weight of said isocyanate compound.

The isocyanate compound having at least one ethylenically unsaturated group used in this invention includes isocyanato compounds of the general formula (33) and isocyanato compounds of the general formula (34) :

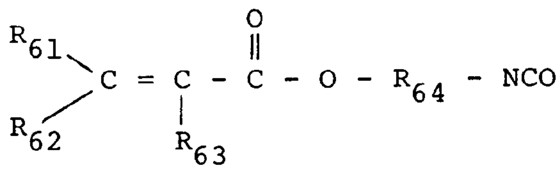

(33)

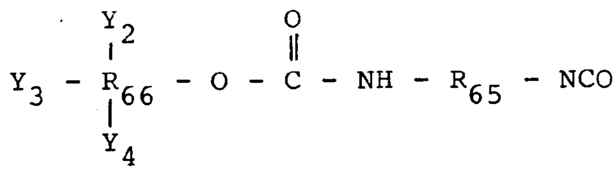

(34)

wherein $R_{61}$, $R_{62}$ and $R_{63}$ are independently a hydrogen atom or a methyl group; $R_{64}$ and $R_{65}$ are independently a divalent hydrocarbon group; $R_{66}$ is a tetravalent orgnic group; and $Y_2$, $Y_3$ and $Y_4$ are independently a group selected from the group consisting of hydrogen atoms and monovalent organic groups having a carbon-carbon double bond, at least one of $Y_2$, $Y_3$ and $Y_4$ being a monovalent organic group having a carbon-carbon double bond.

The isocyanato compounds of the general formula (33) include, for example, isocyanatoethyl acrylate, isocyanatopropyl acrylate, isocyanatobutyl acrylate, isocyanatopentyl acrylate, isocyanatohexyl acrylate, isocyanatooctyl acrylate, isocyanatodecyl acrylate, isocyanatooctadecyl acrylate, isocyanatoethyl methacrylate, isocyanatopropyl methacrylate, isocyanatobutyl methacryalte, isocyanatopentyl methacrylate, isocyanatohexyl methacrylate, isocyanatooctyl methacrylate, isocyanatodecyl methacrylate, isocyanatooctadecyl methacrylate, isocyanatoethyl crotonate, isocyanatopropyl crotonate, methacryloyl isocyanate, acryloyl isocyanate, isocyanatohexyl crotonate, etc. These isocyanato compounds can be used singly or in combiantion of two or more thereof.

Isocyanatoethyl methacrylate is commercially available, for example, from Dow Chemical Co. or Showa Denko K.K.).

The isocyanato compound of the general formula (34) can be synthesized using a hydroxy compound having at least one ethylenically unsaturated group and a diisocyanate compound as starting materials.

The hydroxy compound having at least one ethylenically unsaturated group includes, for example, trimethylolpropane diacrylate, trimethylolpropane dimethacrylate, trimethylolethane diacrylate, trimethylolethane dimethacrylate, pentaerythritol triacrylate, pentaerythritol trimethacrylate, 2-hydroxyethyl acrylate, 2-hdyroxyethyl methacrylate, 2-hydroxypropyl acrylate, 2-hydroxypropyl methacrylate, 2-hydroxy-3-phenoxypropyl acrylate, 2-hydroxy-3-phenoxypropyl methacrylate, allyl alcohol, glycerol diallyl ether, trimethylolpropane diallyl ether, trimethylolethane diallyl ether, pentaerythritol diallyl ether, ethylene glycol monoallyl ether, diethylene glycol monoallyl ether, diglycerol triallyl ether, crotyl alcohol, vinylphenol, cinnamyl alcohol, alkylphenol, o-cinnamylphenol,

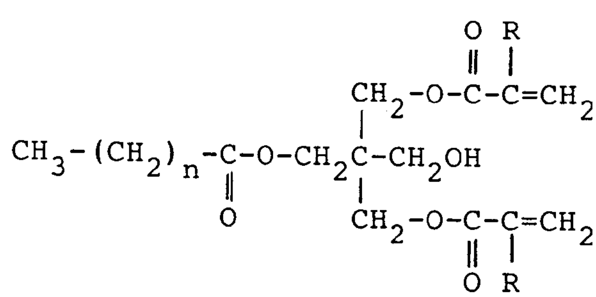

wherein n is an integer of 1 to 30, and R is H or $CH_3$,

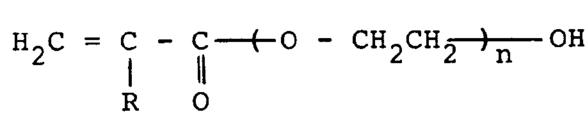

wherein n is an integer of 2 to 30, and R is H or $CH_3$,

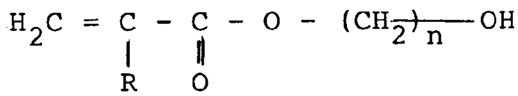

wherein n is an integer of 3 to 30, and R is H or $CH_3$

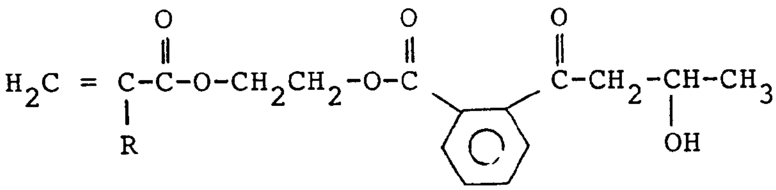

wherein R is H or $CH_3$,

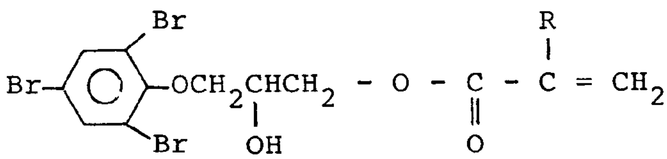

wherein R is H or $CH_3$, etc.

These hydroxy compounds can be used singly or in combination of two or more thereof.

The diisocyanate compound which reacts with hydroxy compound to give an isocyanate compound having a urethane linkage in the molecule, includes for example, 4,4′-diphenylmethane diisocyanate, dianisidine isocyanate, tolidine diisocyanate, hexamethylene diisocyanate, 2,4-tolylene diisocyanate, 2,6-tolylene diisocyanate, methaxylylene diisocyanate, 1,5-naphthalene diisocyanate, trans-vinylene diisocyanate, 2,2,4-trimethylhexamethylene diisocyanate, 2,4,4-trimethylhexamethylene diisocyanate, 3-isocyanatomethyl-3,5,5-trimethylcyclohexyl isocyanate,

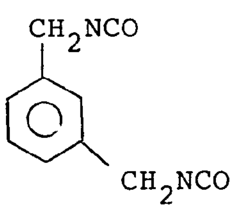 , 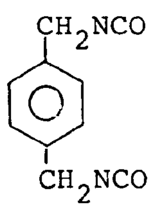 ,

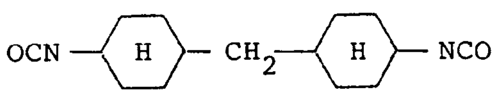 ,

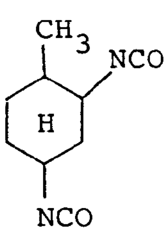 , 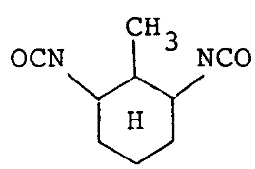 ,

etc.

These diisocyanate compounds can be used singly or in combination of two or more thereof.

The reaction of the hydroxy compound having at least one carbon-carbon double bond in the molecule with the diisocyanate compound is carried out without a solvent or in an inert organic solvent at a temperature of usually 0° to 100°C, preferably 20° to 70°C. The molar ratio of the hydroxy compound to the diisocyanate compound is preferably 0.8/1 - 1.2/1. More preferably, they are used in equimolar amounts.

The reaction of the hydroxy compound having at least one carbon-carbon double bond in the molecule with the diisocyanate compound can be facilitated using an amine such as triethylamine, 1,4-diazobicyclo[2,2,2]-octane, etc. or a tin compound such as dibutyltin diacetate, etc., like a catalyst.

These compounds can be used usually in an amount of about 0.01 to 5% by weight based on the diisocyanate compound.

In addition, the isocyanato compounds of the general formula (33) and the isocyanato compounds of the general formula (34) can be used singly or in combination of two or more thereof.

The isocyanato compounds of the general formula (34) include, for example,

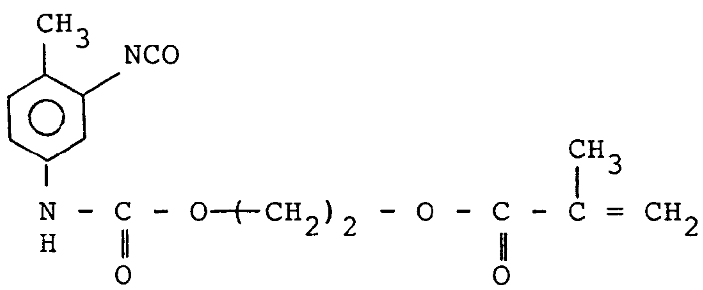

,

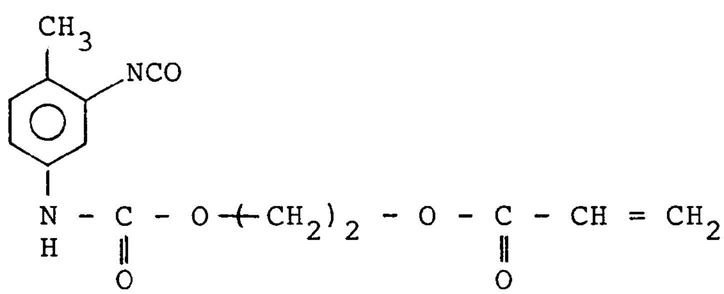

,

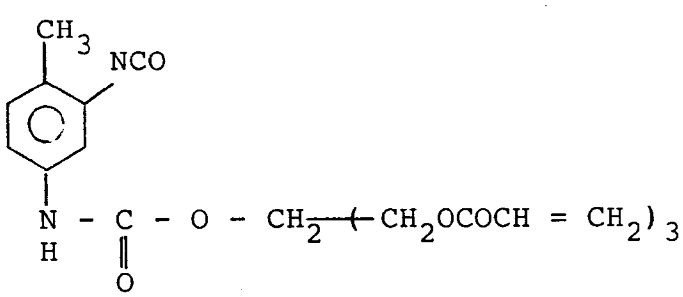

,

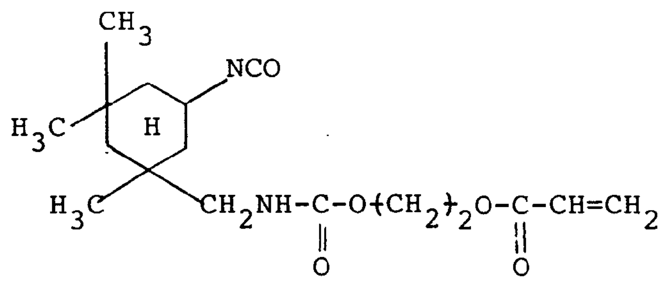

,

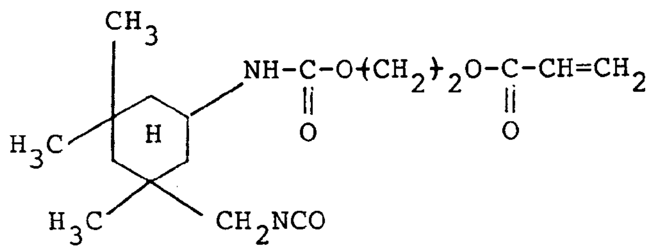

,

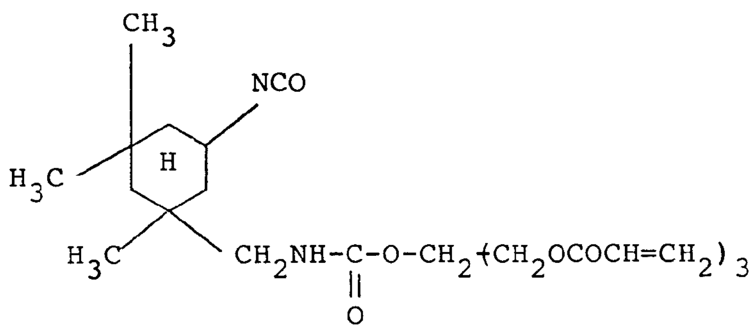

,

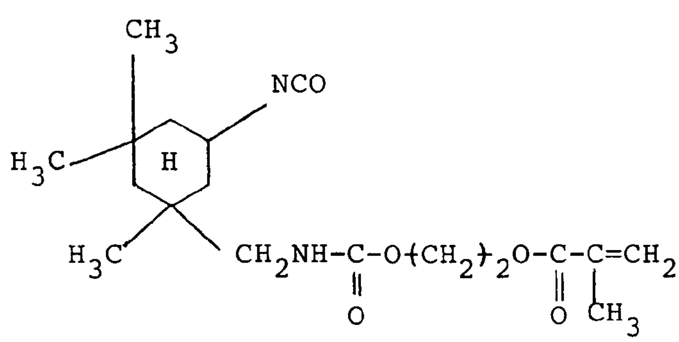

The polymer containing the repeating unit of the general formula (1) can be obtained by a conventional method, for example, by using at least one predetermined tetracarboxylic acid dianhydride and at least one predetermined diamine as starting materials.

In detail, the polymer containing the repeating unit of the general formula (1) can be obtained by a conventional method by choosing a combination of the starting tetracarboxylic acid dianhydride and diamine in which at least the tetracarboxylic acid dianhydride contains one or more silicon atoms in the form of the specified siloxane group and optionally one or more fluorine atoms. The diamine contains may also contain one or more silicon atoms and/or one or more fluorine atoms.

If desired both the tetracarboxylic acid dianhydride and the diamine may contain one or more silicon atoms and one or more fluorine atoms. In this case, the silicon atoms of the diamine are also preferably in the form of a siloxane group.

In the above, the reaction of the tetracarboxylic acid dianhydride with the diamine is carried out in an inert organic solvent preferably at 0° to 100°C, more preferably 10° to 80°C.

As the organic solvent used in the reaction of the tetracarboxylic acid dianhydride with the diamine, there can be used the polar solvents and the common organic solvents which are usable in the above reaction of the polymer containing the repeating unit of the general formula (1) with the isocyanato compound having at least one ethylenically unsaturated group.

In order to dissolve the polymer containing the repeating unit of the general formula (1) completely, the common organic solvents are used preferably in admixture with the polar solvents. The using amount of these organic solvents is preferably 90 to 1,900 parts by weight, more preferably 150 to 500 parts by weight per 100 parts by weight of the polymer containing the repeating unit of the general formula (1).

The tetracarboxylic acid dianhydride and the diamine are used preferably in the ratio of 0.8/1-1.2/1 by mole, more preferably in equimolar amounts.

When as the tetracarboxylic acid dianhydride and the diamine which are used in this invention, there are combined at least one starting tetracarboxylic acid dianhydride and at least one starting diamine at least the acid dianhydride contains one or more siloxane group. Additionally the starting diamine may contain one or more silicon atoms. The resulting silicon atom containing photosensitive resin composition of this invention is excellent in light-transmitting properties and solubility, can be formed into a thick film, and gives a final cured films having excellent adhesive properties and mechanical properties.

From the viewpoint of, for example, the light-transmitting properties of the photosensitive resin composition of this invention, its solubility in a developing solution, and the heat resistance and adhesive properties of a final cured film, the starting materials are preferably used as follows:

(a), a tetracarboxylic acid dianhydride containing neither silicon atom nor fluorine atom and a tetracarboxylic acid dianhydride containing one or more silicon atoms are used in this invention so as to adjust the molar ratio of the tetracarboxylic acid dianhydride containing neither silicon atom nor fluorine atom to the tetracarboxylic acid dianhydride containing one or more silicon atoms to preferably 20/1 - 0.8/1, more preferably 5/1 - 1.5/1, most preferably 3/1 to 2/1;

(b), a diamine containing neither silicon atom nor fluorine atom and a diamine containing one or more silicon atoms are used in this invention so as to adjust the molar ratio of the diamine containing neither silicon atom nor fluorine atom to the diamine conaining one or more silicon atoms to preferably 20/1 - 0.8/1, more preferably 5/1 - 1.5/1, most preferably 3/1 - 2/1;

(c), a tetracarboxylic acid dianhydride containing neither silicon atom nor fluorine atom, a diamine containing neither silicon atom nor fluorine atom, a tetracarboxylic acid dianhydride containing one or more silicon atoms, and a diamine containing one or more silicon atoms are used in this invention so as to adjust the molar ratio of the sum of the tetracarboxylic acid dianhydride containing neither silicon atom nor fluorine atom and the diamine containing neither silicon atom nor fluorine atom to the sum of the tetracarboxylic acid dinahydride containing one or more silicon atoms and the diamine containing one or more silicon atoms to preferably 20/1 - 0.8/1, more preferably 5/1 - 1.5/1, most preferably 3/1 - 2/1.

When as the tetracarboxylic acid dianhydride and the diamine which are used in this invention, there are combined at least one siloxane group-containing starting tetracarboxylic acid dianhydride and at least one starting diamine at least either of which contains one or more fluorine atoms, there are the following three cases:

(i) the starting tetracarboxylic acid dianhydride contains one or more fluorine atoms,

(ii) the starting diamine containing one or more fluorine atoms,

(iii) both the starting tetracarboxylic acid dianhydride and the starting diamine contain one or more fluorine atoms. The resulting photosensitive resin composition of this invention contains one or more fluorine atoms, so that it is excellent in light-transmitting properties and solubility, can be formed into a thick film, and gives a final cured film having excellent electrical properties and mechanical properties.

From the viewpoint of, for example, the light-transmitting properties of the photosensitive resin composition of this invention, its solubility in a developing solution, and the heat resistance and electrical properties of a final cured film, the starting materials are preferably used as follows: in the case of (i), a tetracarboxylic acid dianhydride containing no fluorine atom and a tetracarboxylic acid dianhydride containing one or more fluorine atoms are used in this invention so as to adjust the molar ratio of the tetracarboxylic acid dianhydride containing two fluorine atom to the tetracarboxylic acid dianhydride containing one or more fluorine atoms to preferably 30/1 - 0.8/1, more preferably 5/1 - 1.5/1, most preferably 3/1 - 2/1;

in the case of (ii), a diamine containing no-fluorine atom and a diamine containing one or more fluorine atoms are used in this invention so as to adjust the molar ratio of the diamine containing no fluorine atom to the diamine containing one or more fluorine atoms to preferably 20/1 - 0.8/1, more preferably 5/1 - 1.5/1, most preferably 3/1 - 2/1;

in the case of (iii), a tetracarboxylic acid dianhydride containing neither silicon atom nor fluorine atom, a diamine containing neither silicon atom nor fluorine atom, a tetracarboxylic acid dianhydride containing one or more fluorine atoms, and a diamine containing one or more fluorine atoms are used in this invention so as to adjust the molar ratio of the sum of the tetracarboxylic acid dianhydride containing neither fluorine atom nor silicon atom and the diamine containing neither silicon atom nor fluorine atom to the sum of the tetracarboxylic acid dianhydride containing one or more fluorine atoms and the diamine containing one or more fluorine atoms to preferably 20/1 - 0.8/1, more preferably 5/1 - 1.5/1, most preferably 3/1 - 2/1.

When as the tetracarboxylic acid dianhydride and the diamine which are used in this invention, there are combined at least one starting tetracarboxylic acid dianhydride and at least one starting diamine both of which necessarily contain one or more silicon atoms and one or more fluorine atoms, the resulting photosensitive resin composition contains both silicon atom(s) and fluorine atom(s), so that it is excellent in light-transmitting properties and solubility, can be formed into a thick film, and gives a final cured film having excellent adhesive properties, mechanical properties and electrical properties. Furthermore, the photosensitive resin composition possesses further improved light-transmitting properties and solubility because it contains both silicon atom(s) and fluorine atom(s).

From the viewpoint of, for example, the light-transmitting properties of the photosensitive resin composition of this invention, its solubility in a developing solution, and the electrical properties, heat resistance and adhesive properties of a final cured film, each compound constituting the tetracarboxylic acid dianhydride, i.e., a tetracarboxylic acid dianhydride containing one or more silicon atoms, a tetracarboxylic acid dianhydride containing one or more fluorine atoms, or a tetracarboxylic acid dianhydride containing neither silicon atom nor fluorine atom is used preferably in an amount of 5 to 85 mole %, 5 to 85 mole % or 10 to 90 mole %, respectively, based on the total number of moles of tetracarboxylic acid dianhydrides, more preferably in an amount of 10 to 75 mole %, 10 to 75 mole % or 15 to 80 mole %, respectively, based on the total number of moles of tetracarboxylic acid dianhydride.

The constituent (B), i.e., the polymer containing the repeating unit of the general formula (1), which is used in this invention can be obtained, for example, by polycondensation of a compound of the general formula (7) (hereinafter referred to merely as "compound ①") and/or a compound of the general formula (8) (hereinafter referred to merely as "compound (II)") with a compound of the general formula (9) (hereinafter referred to merely as "compound (III)").

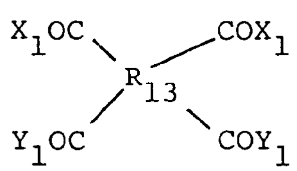

(7)

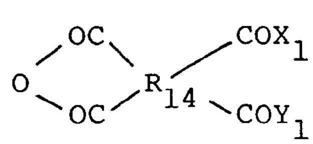

(8)

$$H_2N - R_{15} - NH_2 \qquad (9)$$

wherein $R_{13}$ and $R_4$ have the same meaning as $R_1$ in the general formula (1) has; $R_{15}$ has the same meaning as $R_2$ in the general formula (1) has; $X_1$ is a halogen atom or a hydroxyl group; and $Y_1$ is a monovalent group obtainable by reaction of a corresponding carboxylic acid group with an isocyanato compound containing an ethylenically unsaturated group.

The reaction of compound ① and/or compound (II) with compound (III) is carried out in an inert solvent at a temperature of preferably 0° to 100°C, more preferably 5° to 60°C.

Compound ① and/or compound (II) and compound (III) are preferably used so as to adjust the

molar ratio of compound (I) and/or compound (II) to compound (III) to 0.8/1 - 1.2/1. More preferably, the using amount of compound (I) and/or compound (II) is substantially equmolar with compound (III).

The reaction of compound (I) and/or compound (II) with compound (III) can be accelerated using like a catalyst a carbodiimide type dehydrating-condensation agent such as dicyclohexylcarbodiimide, or a dehydrogenating agent, e.g. an amine such as pyridine or triethylamine.

As the organic solvent used in the above reaction, polar solvents capable of completely dissolving the resulting polymer (B) are generally preferable, and there can be exemplified N-methyl-2-pyrrolidone, N,N-dimethylacetamide, N,N-dimethylformamide, dimethyl sulfoxide, tetramethylurea, hexamethylphosphoric triamide, γ-butyrolactone, N,N-dimethylpropyleneurea, N,N-dimethylethyleneurea, etc.

In addition to these polar solvents, there can be used the common organic solvents usable in the above reaction of the polymer containing the repeating unit of the general formula (II) with the isocyanato compound having at least one ethylenically unsaturated group.

In order to dissolve the polymer (B) completely, the common organic solvents are used preferably in admixture with the above polar solvents. The using amount of these organic solvent is preferably 90 to 1,900 parts by weight, more preferably 150 to 500 parts by weight per 100 parts by weight of the polymer (B).

For isolating the polymer from the reaction mixture as occasion demands, it is preferable to add the reaction mixture in small portions to an alcohol or water.

The solid thus obtained can be purified by repetitions of redissolution in the same organic solvent as used in the reaction and reprecipitation with an alcohol or water.

Compound (I) or compound (II) can be obtained, for example by converting the above-mentioned tetracarboxylic acid dianhydride containing one or more silicon atoms, tetracarboxylic acid dianhydride containing one or more fluorine atoms, or tetracarboxylic acid dianhydride containing neither silicon atom nor fluorine atom, into a half ester by the whole or partial ring opening using a hydroxy compound having at least one ethylenically unsaturated group, and if necessary, converting the half ester into an acid halide by use of thionyl chloride, phosphorus pentachloride or the like. The above reaction of the tetracarboxylic acid dianhydride with a hydroxy compound having at least one ethylenically unsaturated group can be accelerated, for example, by adding pyridine, dimethylaminopyridine, or the like.

As the hydroxy compound having at least one ethylenically unsaturated group, there can be used the hydroxy compounds having at least one ethylenically unsaturated group whcih are usable as a starting material for the isocyanato compound of the general formula (34).

Compounds (I) and/or compounds (II) which are used in this invention are divided into three groups i.e., compounds containing one or more silicon atoms, compounds containing one or more fluorine atoms, and compounds containing neither silicon atom nor fluorine atom. By combining these compounds properly with a diamine containing one or more silicon atoms, a diamine containing one or more fluorine atoms, and/or a diamine containing neither silicon atom nor fluorine atom, there can be obtained any of the following two polymers (B):

(i) a polymer containing silicon atoms

(ii) a polymer containing silicon atoms and fluorine atoms.

In the case of the polymer containing silicon atoms of (i), the photosensitive resin composition of this invention is excellent in light-transmitting properties and solubility, can be formed into a thick film, and gives a final cured film having excellent adhesive properties.

From the viewpoint of, for example, the light-transmitting properties of the photosensitive resin composition of this invention, its solubility in a developing solution, and the heat resistance and adhesive properties of a final cured film, the compound containing neither silicon atom nor fluorine atom, the diamine containing neither silicon atom nor fluorine atom, the compound containing one or more silicon atoms, and the diamine containing one or more silicon atoms are used so as to adjust the molar ratio of the sum of the compound containing neither silicon atom nor fluorine atom and the diamine containing neither silicon atom nor fluorine atom to the sum of the compound containing one or more silicon atoms and the diamine containing one or more silicon atoms to preferably 20/1 - 0.8/1, more preferably 5/1 - 1.5/1.

From the viewpoint of, for example, the light-transmitting properties of the photosensitive resin composition of this invention, its solubility in a developing solution, and the electrical properties of a final cured film, the compound containing neither silicon atom nor fluorine atom, the diamine containing neither silicon atom nor fluorine atom, the compound containing one or more fluorine atoms, and the diamine containing one or more fluorine atoms are used so as to adjust the molar ratio of the sum of the compound containing neither silicon atom nor fluorine atom and the diamine containing neither silicon atom nor fluorine atom to the sum of the compound containing one or more fluorine atoms and the diamine containing one or more fluroine atoms to preferably 20/1 - 0.8/1, more preferably 5/1 - 1.5/1.

As the diamine containing one or more fluorine atoms, it is preferable from the viewpoint of electrical properties to use a diamine represented by the general formula (28-2):

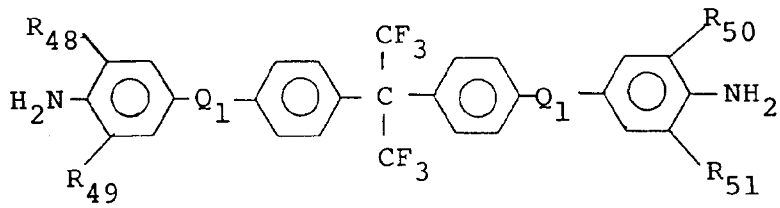

(28-2)

wherein $Q_1$, $R_{48}$, $R_{49}$, $R_{50}$ and $R_{51}$ are independently a hydrogen is an oxygen or sulphur atom; and atom or an alkyl group.

In the case of the polymer containing silicon atoms and fluorine atoms of (ii), the photosensitive resin composition of this invention is excellent in light-transmitting properties and solubility, can be formed into a thick film, and gives a final cured film having excellent adhesive properties and electrical properties.

From the viewpoint of, for example, the light-transmitting properties of the photosensitive resin composition of this invention, its solubility in a developing solution, and the heat resistance and electrical properties of a final cured film, each compound constituting the tetracarboxylic acid dianhydride, i.e., an aromatic tetracarboxylic acid dianhydride containing one or more fluorine atoms, an aromatic tetracarboxylic acid dianhydride having a siloxane group, or an aromatic tetracarboxylic acid dianhydride is used in this invention preferably in an amount of 5 to 85 mole %, 5 to 85 mole % or 10 to 90 mole %, respectively, based on the total number of moles of tetracarboxylic acid dianhydrides, more preferably in an amount of 10 to 75 mole %, 10 to 75 mole % or 15 to 80 mole %, respectively, based on the total number of moles tetracarboxylic acid dianhdyrides

The tetracarboxylic acid dianhydride containing one or more silicon atoms in this invention includes, for example

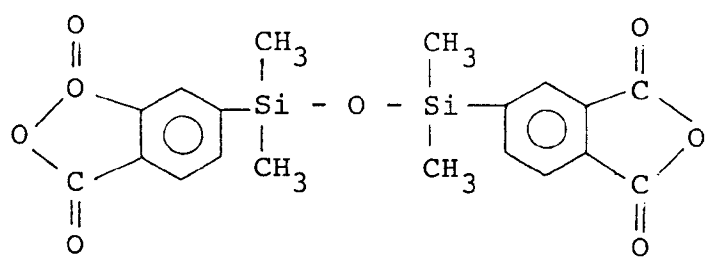

,

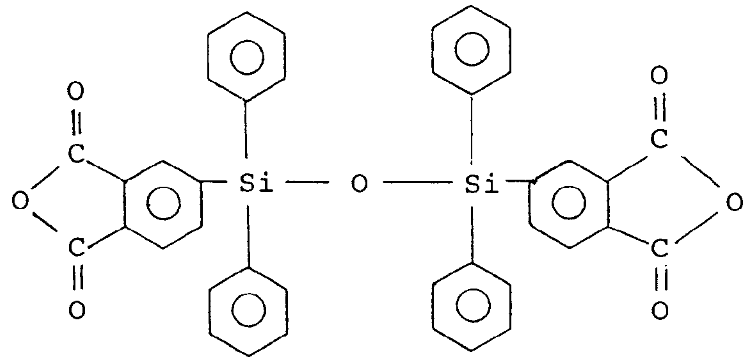

,

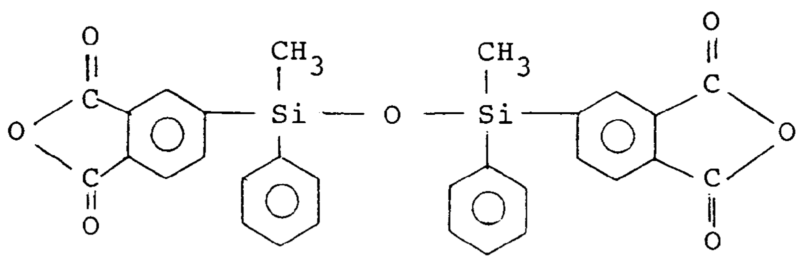

,

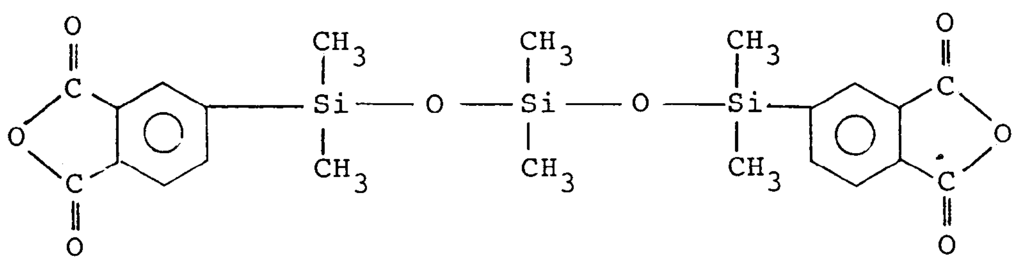

,

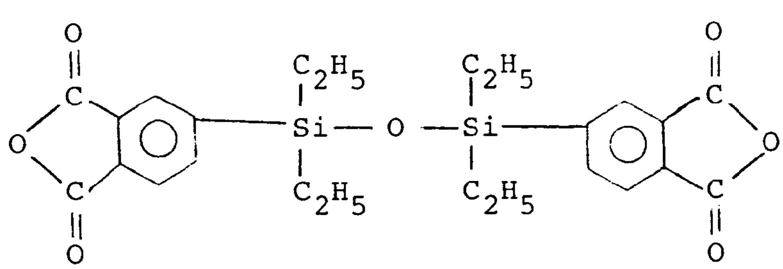

,

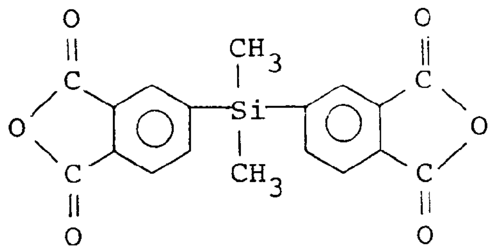

,

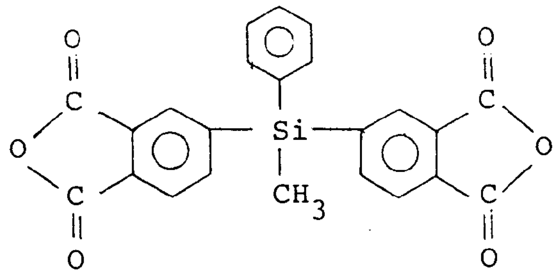

,

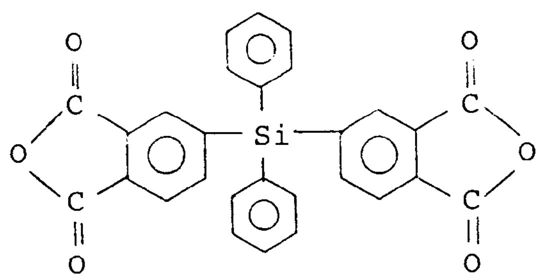

,

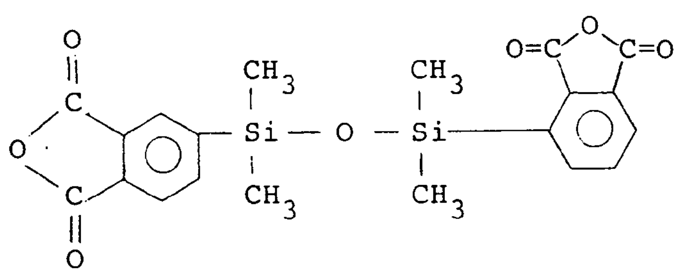

,

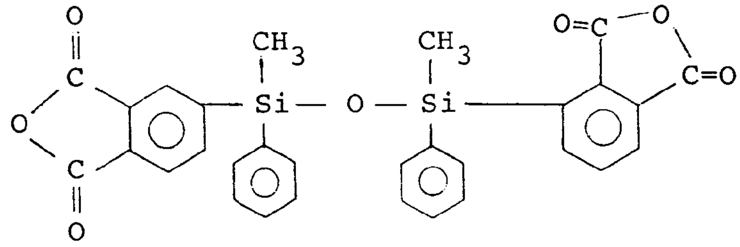

,

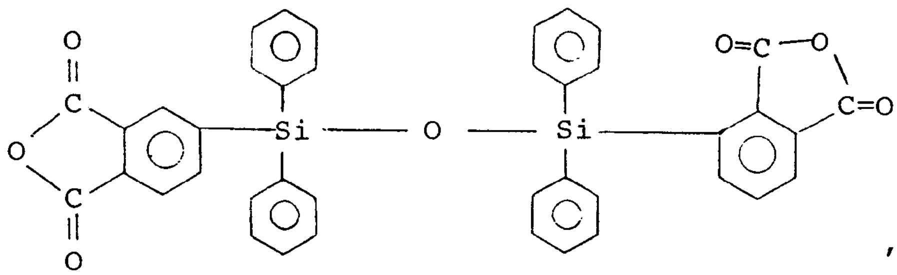

,

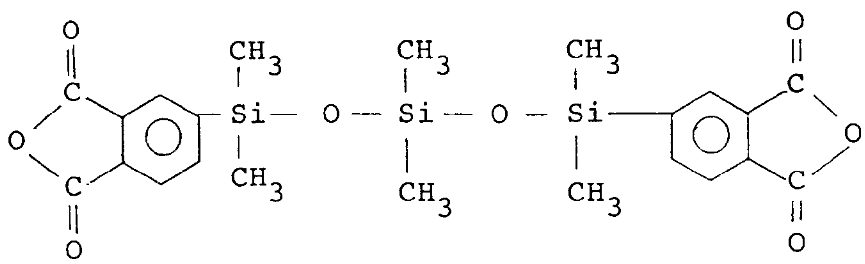

,

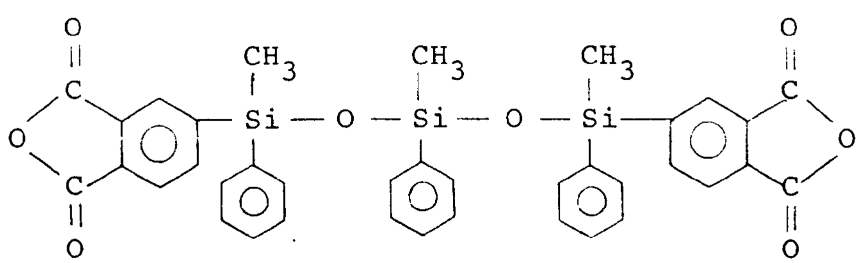

,

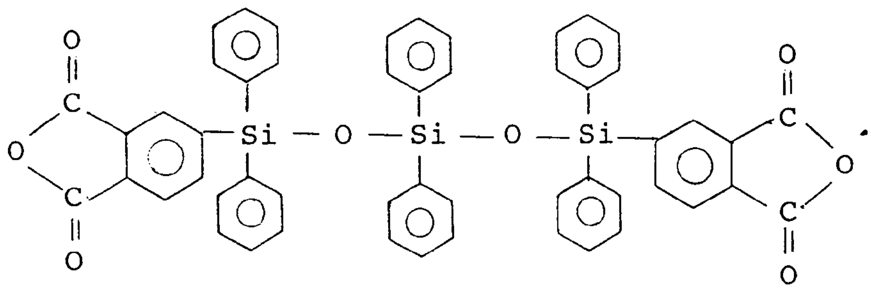

,

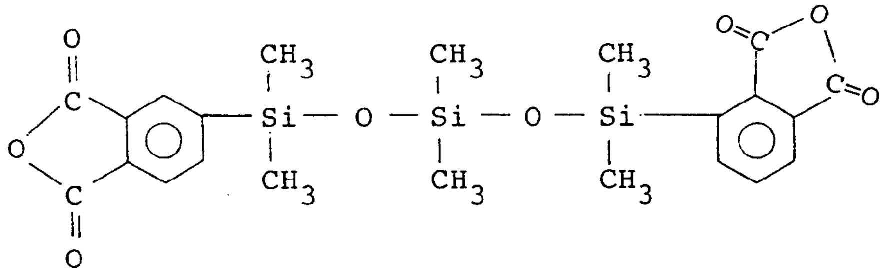

,

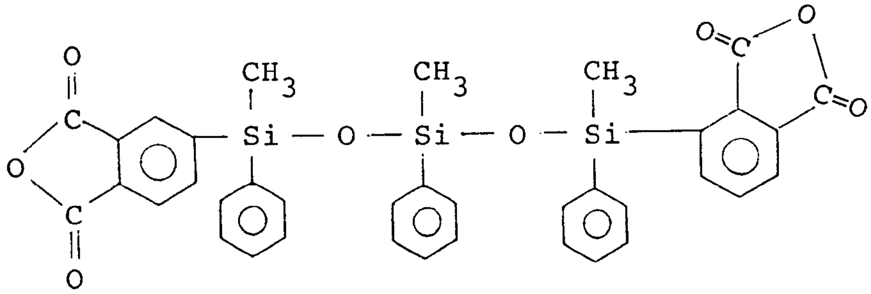

,

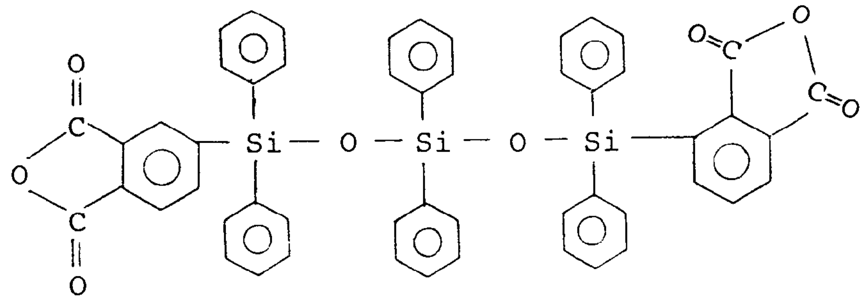

Needless to say, the benzene rings of these tetracarboxylic acid dianhydrides containing one or more silicon atoms may be substituted by substituents such as alkyl groups, etc. These silicon atom containing tetracarboxylic acid dianhydrides can be used singly or in combination of two or more thereof. Among them,

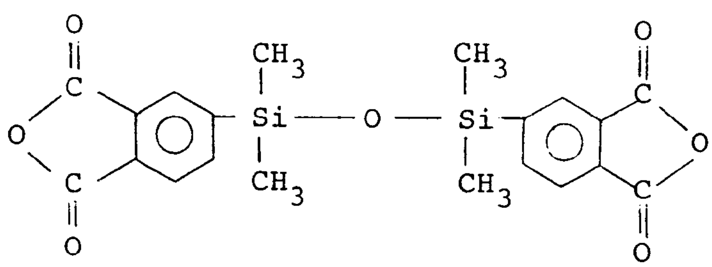

is commercially available from organic synthesis pharmaceutical companies, etc., is easily available, and is preferable from the viewpoint of, for example, the heat resistance of the photosensitive resin composition.

The tetracarboxylic acid dianhydride containing one or more fluorine atoms used in this invention includes, for example, 2,2-bis(3,4-dicarboxyphenyl)hexafluoropropane dianhydride, 2,2-bis[4-(3,4-dicarboxyphenoxy)phenyl]hexafluoropropane dianhydride, 2,2-bis-[4-(2,3-dicarboxyphenoxy)phenyl]hexafluoropropane dianhydride, (trifluoromethyl)pyromellitic dianhydride, bis(trifluoromethyl)pyromellitic dianhydride, 3,3'-bis(trifluoromethyl)-4,4′,5,5′-tetracarboxybiphenyl dianhydride, 2,2′,5,5′-tetrakis(trifluoromethyl)-3,3′,4,4′-tetracarboxybiphenyl dianhydride, 3,3′-bis(trifluoromethyl)-4,4′,5,5′-tetracarboxybiphenyl ether dianhydride, 2,2′-bis(trifluoromethyl)-4,4′,5,5′-tetracarboxybiphenyl ether dianhydride, 3,3′-bis(trifluoromethyl)-4,4′,5,5′-tetracarboxybenzophenone dianhydride, 2,2′-bis(trifluoromethyl)-4,4′,5,5′-tetracarboxybenzophenone dianhydride, 1,4-bis[3-(trifluoromethyl)-4,5-dicarboxyphenoxy]benzene dianhydride, 1,4-bis [2-(trifluoromethyl)-4,5-dicarboxyphenoxy]benzene dianhydride, 4,4′-bis[3-(trifluoromethyl)-4,5-dicarboxyphenoxylbiphenyl dianhydride, 1-trifluoromethyl-2,5-bis[3-(trifluoromethyl)-4,5-dicarboxyphenoxy]benzene dianhydride, 1,1′-bis(trifluoromethyl)-3,3′-bis[3-(trifluoromethyl)-4,5-dicarboxyphenoxy]biphenyl dianhydride, 4,4′-bis[3-(trifluoromethyl)-4,5-dicarboxyphenoxy]biphenyl ether dianhydride, 1-trifluoromethyl-3,5-bis(3,4-dicarboxyphenyl)benzene dianhydride, 1,4-bis(trifluoromethyl)-3,5-bis(3,4-dicarboxyphenyl)benzene dianhydride, 1,2,4,6-tetrakis (trifluoromethyl)-3,5-bis(3,4-dicarboxyphenyl)benzene dianhydride, 1,1′-bis(trifluoromethyl)-3,3′-(3,4-dicarboxyphenoxy)biphenyl dianhydride, 1,1′,4,4′-tetrakis(trifluoromethyl)-3,3′-(3,4-dicarboxyphenoxy) biphenyl dianhydride, 2,2-bis[4-(2,3-dicarboxybenzoyloxy)phenyl]hexafluoropropane dianhydride, 2,2-bis[3-methyl-4-(2,3-dicarboxybenzoyloxy)phenyl]hexafluoropropane dianhydride, 2,2-bis[4-(2-trifluoromethyl-3,4-dicarboxybenzoyloxy)phenyl]hexafluoropropane dianhydride, 1,5-bis[4-(3,4-dicarboxybenzoyloxy)phenyl]decafluoropentane dianhydride, 1,3-bis[4-(3,4-dicarboxybenzoyloxy)phenyl]hexafluoropropane dianhydride, 1,6-bis[4-(3,4-dicarboxybenzoyloxy)phenyl]dodecafluorohexane dianhydride, 2,2-bis[3,5-dimethyl-4-(3,4-dicarboxyphenoxy)phenyl]hexafluoropropane dianhydride, 2,2-bis[4-(3,4-dicarboxyphenoxy)phenyl]octafluorobutane dianhydride, 2,2-bis-[4-(2-trifluoromethyl-3,4-dicarboxy)phenyl]hexafluoropropane dianhydride, 1,3-bis[4-(3,4-dicarboxyphenoxy)phenyl]hexafluoropropane dianhydride, 1,5-bis[4-(3,4-dicarboxyphenoxy)phenyl]decafluoropentane dianhydride, 1,6-bis[4-(3,4-dicarboxyphenoxy)phenyl]dodecafluoropropane dianhydride, etc. These fluorine atom containing tetracarboxylic acid dianhydrides can be used singly or in combination of two or more thereof. Of these, 2,2-bis(3,4-dicarboxyphenyl)hexafluoropropane dianhydride is commercially available from Central Glass Co., Ltd., Hoechst Celanese Corp., etc., is easily available, and is preferable from the viewpoint of the heat resistance of the photosensitive resin composition.

The tetracarboxylic acid dianhydride containing neither silicon atom nor fluorine atom used in this invention includes pyromellitic dianhydride, 3,3′,4,4′-benzophenonetetracarboxylic dianhydride, 3,3′,4,4′-biphenyltetracarboxylic dianhydride, m-terphenyl-3,3′,4,4′-tetracarboxylic dianhydride, p-terphenyl-3,3′,4,4′-tetracargoxylic dianhydride, 1,2,5,6-naphthalenetetracarboxylic dianhydride, 2,3,6,7-naphthalenetetracarboxylic dianhydride, 2,3,5,6-pyridinetetracarboxylic dianhydride, 1,4,5,8-naphthalenetetracarboxylic dianhydride, 3,4,9,10-perylenetetracarboxylic dianhydride, 4,4′-sulfonyldiphthalic dianhydride, bis(3,4-dicaboxyphenyl) ether dianhydride, 2,2-bis(3,4-dicarboxyphenyl)propane dianhydride, butanetetracarboxylic dianhydride, cyclobutanetetracarboxylic dianhydride, 5-(2,5-dioxatetrahydrofuryl)-3-methyl-3-cyclohexene-1,2-dicarboxylic dianhydride, dicyclohexyl-3,4,3′,4′-tetracarboxylic dianhydride, etc. These tetracarboxylic acid dianhydrides containing neither silicon atom nor fluorine atom can be used singly or in combiantion of two or more thereof.

Needless to say, the benzene rings of these tetracarboxylic acid dianhydrides may be substituted by substituents such as alkyl groups, etc.

The diamine containing one or more silicon atoms used in this invention includes, for example,

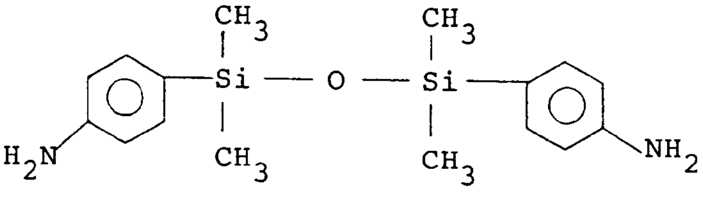

,

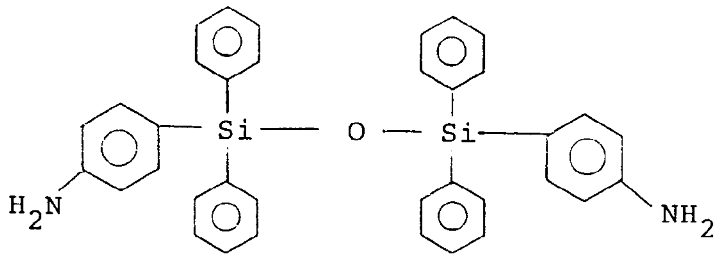

,

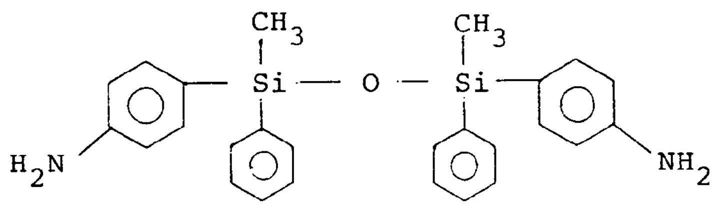

,

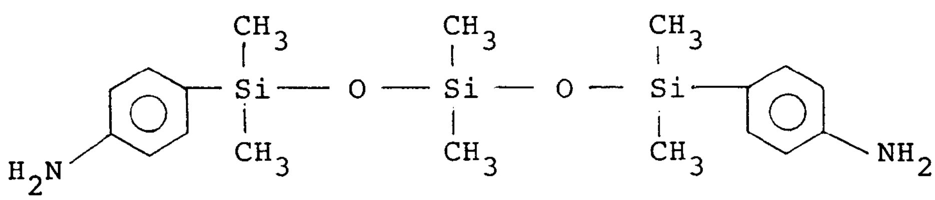

,

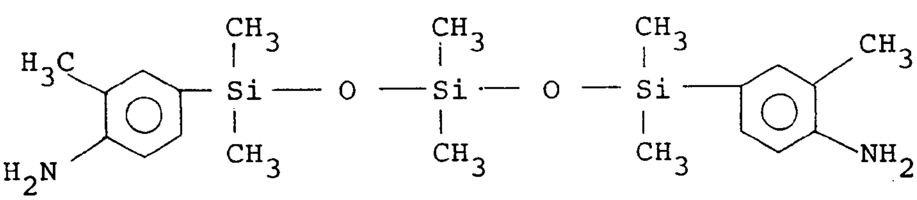

,

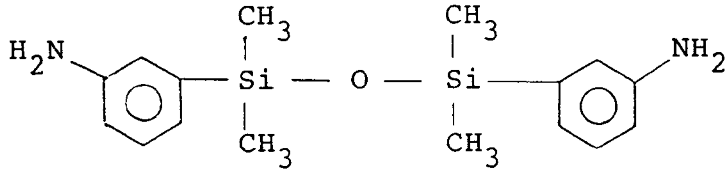

,

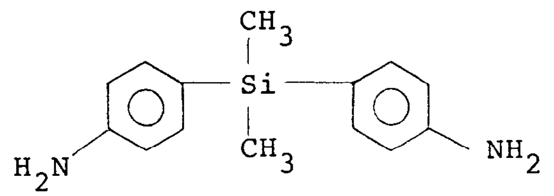

,

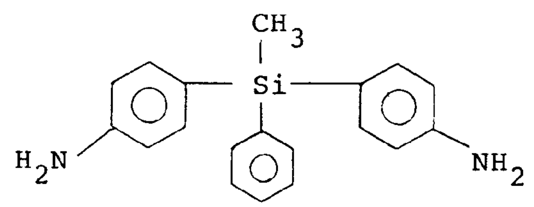

,

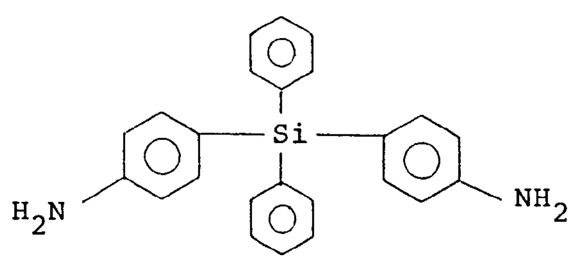

,

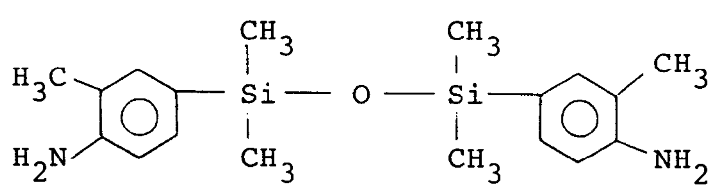

,

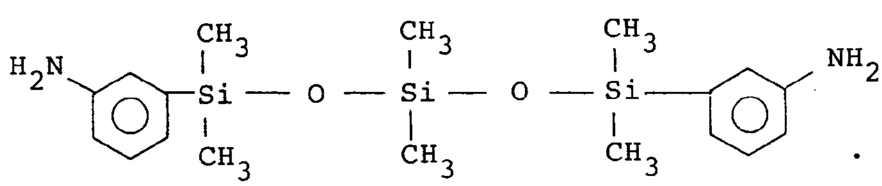

.

These silicon atom-containing diamines can be used singly or in combination of two or more thereof.

The diamine containing one or more fluorine atoms used in this invention includes, for example, 2,2-bis(4-aminophenyl)hexafluoropropane, 2,2-bis(3-amino-4-methylphenyl)hexafluoropropane, 2,2-bis(3-methyl-4-aminophenyl)hexafluoropropane, 2,2-bis(3,5-dimethyl-4-aminophenyl)hexafluoropropane, 2,2-bis[4-(4-aminophenoxy)phenyl]hexafluoropropane, 2,2-bis[4-(3-aminophenoxy)phenyl]hexafluoropropane, 2,2-bis[4-(2-aminophenoxy)phenyl]hexafluoropropane, 2,2-bis[3,5-dimethyl-4-(4-aminophenoxy)phenyl]hexafluoropropane, 1,4-bis[2-(trifluoromethyl)-4-aminophenoxy]benzene, 4,4′-bis-[2-(trifluoromethyl)-4-aminophenoxy)biphenyl, 4,4′-bis[2-(trifluoromethyl)-4-aminophenoxy]diphenyl sulfone, 4,4′-bis[4-(4-aminophenylthio)-phenyl]biphenyl, 2,2′-bis[4-(4-aminophenylthio)-phenyl]hexafluoropropane, 2,2′-bis[4-(2-trifluoromethyl-4-aminophenoxy)phenyl]phenyl]hexafluoropropane, etc. These fluorine atom-containing diamines can be used singly or in combination of two or more thereof. Of these, 2,2-bis(4-aminophenyl)hexafluoropropane and 2,2-bis[4-(4-aminophenoxy)phenyl]hexafluropropane are commercially available from Central Glass Co., Ltd., are easily available, and are preferable from the viewpoint of the heat resistance of the photosensitive resin composition.

The diamine containing neither silicon atom nor fluorine atom used in this invention includes, for example, 4,4′-diaminodiphenyl ether, 3,4′-diaminodiphenyl ether, 4,4′-diaminodiphenylmethane, 4,4′-diaminodiphenyl sulfone, 4,4′-diaminodiphenyl sulfide, benzidine, m-phenylenediamine, p-phenylenediamine, 1,5-naphthalenediamine, 2,6-naphthalenediamine, 2,2-bis(4-aminophenoxyphenyl)propane, bis(4-aminophenoxyphenyl) sulfone, 4,4′-diaminodiphenylethane, 3,3′-diaminobenzophenone, 4,4′-diaminobenzophenone, 3,3′-dimethyl-4,4′-diaminobiphenyl 3,4′-diaminobenzanilide, m-xylenediamine, p-xylylenediamine, etc.

These diamines containing neither silicon atom nor fluorine atom can be used singly or in combiantion of two or more thereof.

In addition to them, there can also be used diaminoamide compounds represented by the general formula:

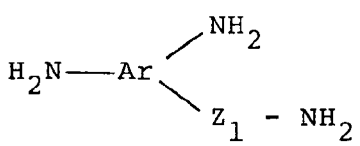

(38)

wherein Ar is an aromatic group; $Z_1$ is $SO_2$ or CO; and one of the amino groups and $Z_1$ - $NH_2$ are in ortho positions in relation to each other.

The compounds of the general formula (38) include, for example, 4,4′-diaminodiphenylether-3-sulfonamide, 3,4′-diaminodiphenylether-4-sulfonamide, 3,4′-diaminodiphenylether-3′-sulfonamide, 3,3′-diaminodiphenylether-4-sulfonamide, 4,4′-diaminodiphenylmethane-3-sulfonamide, 3,4′-diaminodiphenylmethane-4-sulfonamide, 3,4′-diaminodiphenylmethane-3′-sulfomamide, 3,3′-diaminodiphenylmethane-4-sulfonamide, 4,4′-diaminodiphenylsulfone-3-sulfonamide, 3,4′-diaminodiphenylsulfone-4-sulfonamide,3,4′-diaminodiphenylsulfone-3′-sulfonamide, 3,3′-diaminodiphenylsulfone-4-sulfonamide, 4,4′-diaminodiphenylsulfide-3-sulfonamide, 3,4′-diaminodiphenylsulfide-4-sulfonamide, 3,3′-diaminodiphenylsulfide-4-sulfonamide, 3,4′-diaminodiphenylsulfide-3′-sulfonamide, 1,4-diaminobenzene-2-sulfonamide, 4,4′-diaminodiphenylether-3-carbonamide, 3,4′-diaminodiphenylether-4-carbonamide, 3,4′-diaminodiphenylether-3′-carbonamide, 3,3′-diaminodiphenylether-4-carbonamide, 4,4′-diaminodiphenylmethane-3-carbonamide, 3,4′-diaminodiphenylmethane-4-carbonamide, 3,4′-diaminodiphenylmethane-3′-carbonamide, 3,3′-diaminodiphenylmethane-4-carbonamide, 4,4′-diaminodiphenylsulfone-3-carbonamide, 3,4′-diaminodiphenylsulfone-4-carbonamide, 3,4′-diaminodiphenylsulfone-3′-carboanmide, 3,3′-diaminodiphenylsulfone-4-carbonamide, 4,4′-diaminodiphenylsulfide-3-carbonamide, 3,4′-diaminodiphenylsulfide-4-carbonamide, 3,3′-diaminodiphenylsulfide-4-carbonamide, 3,4′-diaminodiphenylsulfide-3′-sulfonamide, 1,4-diaminobenzene-2-carbonamide, etc.

These diaminoamide compounds can be used singly or in combination of two or more thereof.

If necessary, there can also be used diaminodiamide compounds represented by the general formula:

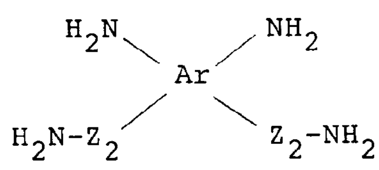

(39)

wherein Ar is an aromatic group; $Z_2$ is $SO_2$ or CO; and one of the amino groups and one the $Z_2$-$NH_2$ groups are in ortho positions in relation to each other.

The compounds of the general formula (39) include, for example, 4,4′-diaminodiphenylether-3,3′-sulfonamide, 3,4′-diaminodiphenylether-4,5′-carbonamide, 3,3′-diaminodiphenylether-4,4′-sulfonamide, 4,4′-diaminodiphenylmethane-3,3′-carbonamide, 3,4′-diaminodiphenylmethane-4,5′-sulfonamide, etc.

These diaminodiamide compounds can be used singly or in combiantion of two or more thereof.

The constituent (A), the photoinitiator, which is used in this invention includes, for example, Michler's ketone, benzoin, 2-methylbenzoin, benzoin methyl ether, benzoin ethyl ether, benzoin isopropyl ether, benzoin

butyl ether, 2-t-butylanthraquinone, 1,2-benzo-9,10-anthraquinone, anthraquinone, methylanthraquinone, 4,4′-bis(diethylamino)benzophenone, acetophenone, benzophenone, thioxanthone, 2,4-diethylthioxanthone, 1,5-acenaphthene, 2,2-dimethoxy-2-phenylacetophenone, 1-hydroxycyclohexyl phenyl ketone, 2-methyl-[4-(methylthio)phenyl]2-morpholono-1-propanone, diacetyl, benzil, benzyldimethylketal, benzyldiethylketal, diphenyl disulfide, anthracene, phenanthrenequinone, riboflavin tetrabutyrate, Acryl Orange, Erythrosine, phenanthrenequinone, 2-isopropylthioxanthone, 3,3-carbonyl-bis(7-diethylamino)coumarin, 2,6-bis(p-diethylaminobenzylidene)-4-methyl-4-azacyclohexanone, 6-bis(p-dimethylaminobenzylidene)-cyclopentanone, 2,6-bis(p-diethylaminobenzylidene)-4-phenylcyclohexanone, and aminostryl ketone of the formula:

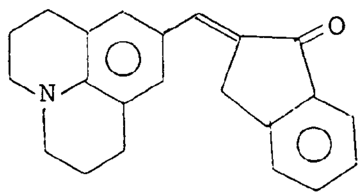

These photoinitiators of (A) can be used singly or in combination of two or more thereof.

Assistants of photoinitiator (I), such as amines and amino acids can be used together with these photoinitiators of (A).

The amines include, for example, ethyl p-dimethylaminobenzoate, methyl p-diethylaminobenzoate, ethyl p-diethylaminobenzoate, ethyl p-dimethylaminobenzoate, isoamyl p-dimethylaminobenzoate, p-dimethylaminobenzonitrile, ethyl N,N-dimethylanthranilate, etc.

The amino acids include, for example, N-phenylglycine, N-methyl-N-(p-chlorophenyl)glycine, N-ethyl-N-(p-chlorophenyl)glycine, N-(n-propyl)-N-(p-chlorophenyl)glycine, N-methyl-N-(p-bromophenyl)glycine, N-ethyl-N-(p-bromophenyl)glycine, N-(p-cyanophenyl)-glycine, N-(p-chlorophenyl)glycine, N-(p-bromophenyl)glycine, etc.

These photoinitiators can be used singly or in combination of two or more thereof.

Assistants of photoinitiator (II) such as mercaptan compounds and oxime compounds can be used together with the photoinitiator of (A) and the assistant of photoinitiator (I).

The mercaptan compounds include, for example, 2-mercaptobenzimidazole, 1-phenyl-5-mercapto-1,2,3,4-tetrazole, 2-mercaptobenzothiazole, 2-benzoxazolethiol, thiomalic acid, 3-mercaptopropionic acid, etc.

The oxime compounds include, for example, 1-phenyl-propanedione-2- (o-ethoxycarbonyl) oxime, 1-phenyl-butanedione-2-(o-methoxycarbonyl)oximie, 1-phenyl-propanedione-2-(o-benzoyl)oxime, 1,2-diphenylethanedione-1-(o-benzoyl)oxime, 1,3-diphenyl-1,2,3-propanetrione-7-(o-n-propylcarbonyl)oxime, 1-(4′-methoxyphenyl)-3-(4′-nitrophenyl)-1,2,3-propanetrione-2-(o-phenyloxycarbonyl)oxime, 1,3-bis(4′-methoxyphenyl)1,2,3-propanetrione-2-(o-ethoxycarbonyl)oxime, etc.

The using amount of the above-exemplified assistant of photoinitiator (I) and assistants of photoinitiator (II) is usually preferably 0.01 to 30 parts by weight, more preferably 0.1 to 10 parts by weight per 100 parts by weight of the constituent (B), from the viewpoint of the sensitivity of the photosensitive resin composition, the heat resistance of a coating film.

A conventional thermopolymerization inhibitor can be incorporated into the photosensitive resin composition in order to improve the thermal stability of said composition.

The thermopolymerization inhibitor includes, for example, p-methoxyphenol, hydroquinone, t-butylcatechol, pyrogallol, phenothiazine, chloranil, naphthylamine, β-naphthol, 2,6-di-t-butyl-p-cresol, pyridine, nitrobenzene, p-toluidine, methylene blue, 2,2′-5 methylenebis(4-methyl-6-t-butylphenol), 2,2′-methylene-bis(4-ethyl-6-t-butylphenol), etc.

The resin composition according to this invention also contains one or more polymerizable unsaturated compounds (C). Among them, acrylic acid compounds and methacrylic acid compounds, are practical.

Specific examples of the acrylic acid compounds are acrylic acid, methyl acrylate, ethyl acrylate, n-propyl acrylate, isopropyl acrylate, n-butyl acrylate, isobutyl acrylate, cyclohexyl acrylate, benzyl acrylate, carbitol acrylate, methoxyethyl acrylate, ethoxyethyl acrylate, butoxyethyl acrylate, hydroxyethyl acrylate, hydroxypropyl acrylate, butylene glycol monoacrylate, N,N-dimethylaminoethyl acrylate, N,N-diethylaminoethyl acrylate, glycidyl acrylate, tetrahydrofurfuryl acryalte, pentacrythritol monoacryalte, trimethylolpropane monoacrylate,

allyl acrylate, 1,3-propylene glycol diacrylate, 1,4-butylene glycol diacrylate, 1,6-hexane glycol diacrylate, neopentyl glycol diacrylate, dipropylene glycol diacrylate, 2,2-bis(4-acryloxydiethoxyphenyl)propane, 2,2-bis(4-acryloxypropyloxyphenyl)propane, trimethylolpropane diacrylate, pentacrythritol diacrylate, trimethylolpropane triacrylate, pentacrylthritol triacrylate, triacrylformal, tetramethylolmethane tetraacrylate, acrylic ester of tris(2-hydroxyethyl)isocyanuric acid,

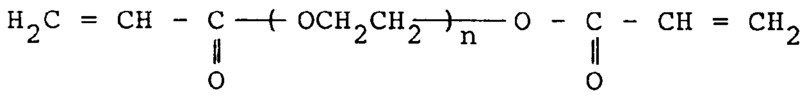

wherein n is an integer of 1 to 30,

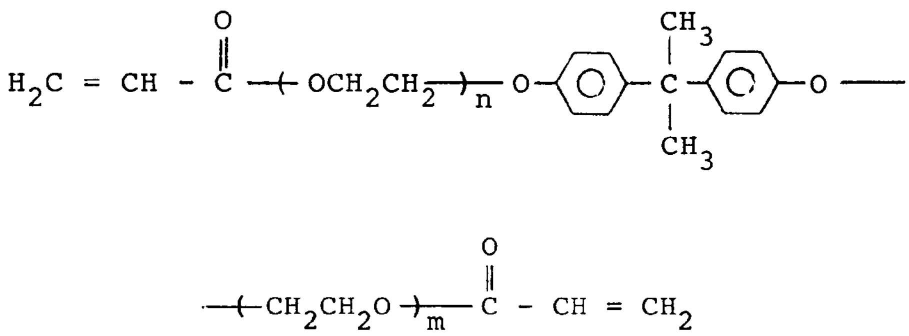

wherein n and m are independently integers and chosen so as to adjust n + m to 2 - 30,

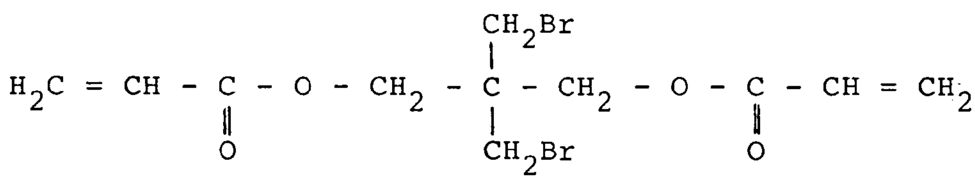

,

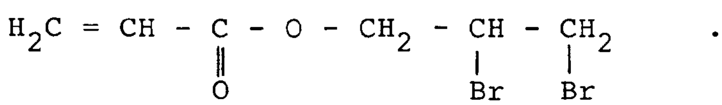

The methacrylic acid compounds include, for example, methacrylic acid, methyl methacrylate, ethyl methacrylate, propyl methacrylate, isopropyl methacrylate, butyl methacrylate, isobutyl methacrylate, cyclohexyl methacrylate, benzyl methacrylate, octyl methacrylate, ethylhexyl methacrylate, methoxyethyl methacrylate, ethoxyethyl methacrylate, butoxyethyl methacrylate, hydroxyethyl methacrylate, hydroxypropyl methacrylate, hydroxybutyl methacrylate, hydroxypentyl methacrylate, N,N-dimethyl aminomethacrylate, N,N-diethyl aminomethacrylate, glycidyl methacrylate, tetrahydrofurfuryl methacrylate, methacryloxypropyltrimethoxysilane, allyl methacrylate, trimethylolpropane monomethacrylate, pentaerythritol monomethacrylate, 1,3-butylene glycol dimethacrylate, 1,6-hexane glycol dimethacrylate, neopentyl glycol dimethacrylate, 2,2-bis(4-methacryloxydiethoxyphenyl)propane, trimethylolpropane dimethacrylate, pentaerythritol dimethacrylate, trimethylolpropane triacrylate, pentaerythritol trimethacrylate, tetramethylolmethane tetramethacrylate, methacrylic ester of tris(2-hydroxyethyl)isocyanuric acid,

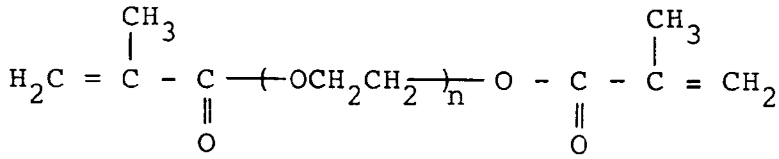

wherein n is an integer of 1 to 30,

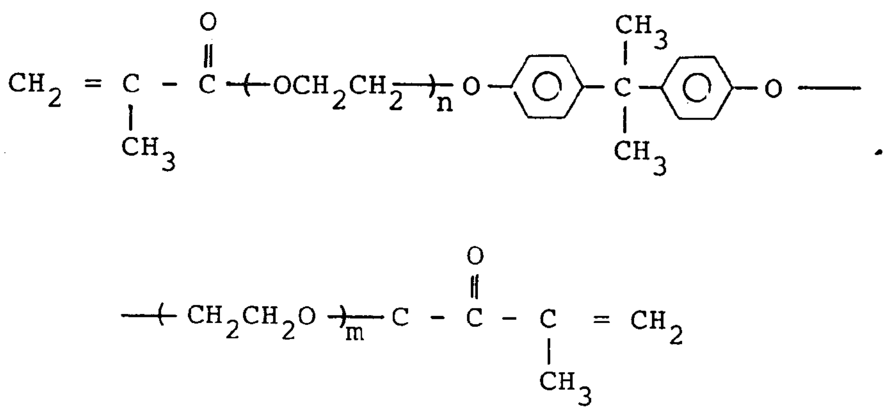

wherein n and m are independently integers and chosen so as to adjust n + m to 1 - 30,

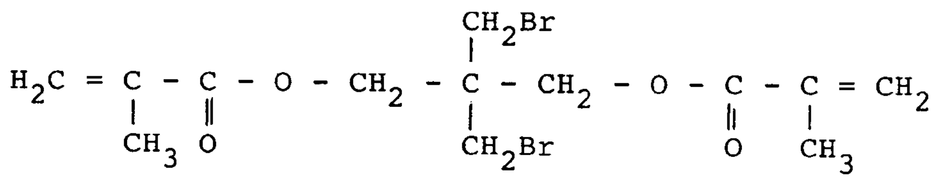

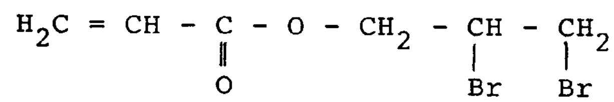

These compounds can be used singly or in combination of two or more thereof.

The photosensitive resin composition of this invention may contain other polymers, i.e., organic fillers such as poly(amic acid)s, polyimides, polyamides, polyether imides (or precursors thereof), polyamideimides (or precursors thereof), epoxy resins, acrylic resins, resol resins, novolak resins, urethane resins, melamine resins, polyester resins, silicone resins, etc. In this case, any of these resins may be contained so long as it is miscible with the polymer (B), and these resins are contained in such an amount that they do not deteriorate the heat resistance, adhesive properties, electrical properties and mechanical properties of a final cured film.

The photosensitive resin composition of this invention may contain organic solvents.

As the organic solvents, there can be used, for example, solvents which are capable of completely dissolving the constituent (B). In this case, the using amount of the organic solvents is preferably 10 to 95% by weight, more preferably 30 to 80% by weight based on the weight of the photosensitive resin composition.

The photosensitive resin composition of this invention can be subjected to pattern formation by a conventional micro-fabrication technique.

The photosensitive resin composition of this invention can be formed into a coating film by coating the same on a base material such as glass substrate, silicon wafer, copper-clad laminate or the like by a means such as spin coating using a spinner, dipping, spraying, printing or the like, and then drying the coating.

The thickness of the coating film can be adjusted by properly choosing a coating means, the solid concentration and viscosity of a varnish of the photosensitive polymer composition of this invention, etc.

A coating film can be formed on a substrate to be coated, also by coating the photosensitive resin composition on a flexible base material, e.g. a polyester film, drying the same, thereby laminating the same on the substrate, optionally forming thereon a cover sheet of polyethylene or the like to produce a photosensitive element having a sandwich structure previously, and peeling off the cover sheet of the photosensitive element.

A cover sheet need not necessarily to be used.

When the coating film is irradiated with actinic rays through a mask having a desired pattern, polymerization occurs in the exposed portion, so that the exposed portion is greatly decreased in solubility as compared with the unexposed portion.

Although ultraviolet rays are usually used as the actinic rays, the same effect on the coating film as in the case of ultraviolet rays can be obtained by irradiating the coating film, if necessary, with ionizing radiation such as electron beams, radiation or the like.

When the coating film treated in the manner described above is treated with a suitable developing solution, the unexposed portion retaining a high solubility is developed and removed, while the exposed portion which has been decreased in solubility by the irradiation with actinic rays remains, whereby a desired resin pattern can be obtained.

As the developing solution, there can be used, for example, polar solvents such as N-methyl-2-pyrrolidone, N-acetyl-2-pyrrolidone, N,N-dimethylformamide, N,N-dimethylacetamide, dimethyl sulfoxide, hexamethylphosphortriamide, dimethylimidazolidinone, N-benzyl-2-pyrrolidone, N-acetyl-ε-caprolactam, N,N-dimethylpropyleneurea, N,N-dimethylethyleneurea, γ-butyrolactone, etc. These polar solvents can be used alone or as a mixed solution with common organic solvents such as methanol, ethanol, isopropanol, benzene, acetone, methyl ethyl ketone, cyclohexanone, cyclopentanone, toluene, xylene, methyl Cellosolve, ethyl acetate, methyl propionate, tetrahydrofuran, dioxane and the like, water, basic compounds, basic aqueous solutions, etc. Basic aqueous solutions alone or solutions prepared by mixing a basic aqueous solution with an alcohol can also be used as the developing solution.

The basic compounds include, for example, monoethanolamine, diethanolamine, triethanolamine, tetramethylammonium hydroxide, sodium carbonate, potassium carbonate, sodium phosphate, etc.

As the basic compounds, there can be used hydroxides, carbonates, hydrogencarbonates, silicates, phosphates, pyrophosphates, acetates, amines, etc. of alkali metals and quaternary ammonium.

Specific examples of these basic compounds are lithium hydroxide, sodium hydroxide, potassium hydroxide, ammonium hydroxide, trimethylbenzylammonium hydroxide, tetramethylammonium hydroxide, sodium carbonate, potassium carbonate, sodium hydrogencarbonate, sodium silicate, sodium phosphate sodium pyrophosphate, sodium acetate, monoethanolamine, diethanolamine, triethanolamine, etc.

In preparing a basic aqueous solution of the basic compound, the using amount of the basic compound is usually preferably 0.0001 to 30 parts by weight, more preferably 0.05 to 5 parts by weight per 100 parts of water.

The alcohol includes, for example, methanol, ethanol, isopropanol, n-propanol, n-butanol, n-pentanol, n-hexanol, n-heptanol, n-octanol, etc.

Subsequently, the developing solution can be removed by rinsing the relief pattern formed by the development with a rinsing liquid.

As the rinsing liquid, there can be used non-solvents for poly(amic acid) which are highly miscible with the developing solution, for example, methanol, ethanol, isopropanol, benzene, toluene, xylene, methyl Cellosolve, water etc.

The thus obtained resin pattern of thick film can be converted to a semiconductor element having a high heat resistance, an interlaminar insulating film or surface-protective film in a multilayer circuit board or the like, a color filter, etc. by subsequent baking at 150° to 400°C, i.e., post cure, and then if necessary, exposure to actinic rays. Therefore, the photosensitive resin composition of this invention is very useful mainly in the field of the micro-fabrication described above.

This invention is explained below with reference to Examples and Comparative Examples, which are not by way of limitation but by way of illustration.

Referential Example 1

In a 200-ml four-necked flask equipped with a thermometer, a nitrogen gas inlet and a stirrer were placed 17.4 g (0.1 mole) of 2,4-tolylene diisocyanate, 100 ml of dried methyl ethyl ketone and 2 mg of dibutyltin dilaurate, and stirred at room temperature while introducing dried nitrogen gas.

Subsequently, 11.6 g (0.1 mole) of 2-hydroxyethyl acrylate was added and the resulting solution was stirred at room temperature for 8 hours, after which the methyl ethyl ketone was removed to obtain an isocyanato compound.

In $^1$H-NMR spectrum of the product, there were observed a signal due to $-OCH_2CH_2O-$ at 4.35 ppm and a signal due to $-CH=CH_2$ at 5.7 - 6.4 ppm.

In IR spectrum of the product, an absorption due to amide group carbonyl stretching vibration was observed at 1650 $cm^{-1}$. The isocyanato compound obtained was named TD-HEA.

Referential Example 2

In a 1000-ml flask equipped with a thermometer and a stirrer were placed 133.2 g of 2,2-bis(3,4-dicarboxyphenyl)hexafluoropropane dianhdyride (mfd. by Central Glass Co., Ltd.) and 450 g of N-methyl-2-pyrrolidone as solvent, and stirred at room temperature.

Then, 60.1 g of 4,4′-diaminodiphenyl ether (mfd. by Mitsui Toatsu Chemicals, Inc.) was added to the resulting solution, and the resulting mixture was stirred at room temperature for 4 hours to obtain a viscous polymer solution.

Subsequently, 43.5 g of the isocyanato compounds TD-HEA obtained in Referential Example 2 was added to the polymer solution and stirred for 8 hours at room temperature while shutting out the light. Carbon dioxide was generated during the reaction. The photosensitive adduct solution was named PI-1.

Synthetic Examples 1 to 8

In the same manner as in Referential Example 2, Polymers PI-27-29,36-38, 41 and 42 were obtained by using tetracarboxylic acid dianhydride(s), diamine(s) and an isocyanato compound having at least one ethylenic unsaturated group, in the blending amounts shown in Table 1. Each of the polymers obtained in Synthetic Examples 1 to 6 was solidified by adding 80 ml of ethanol, followed by stirring for 3 hours and slow pouring into 8 liters of water.

Synthetic Example 9

To a mixture of 20.7 g (0.04 mole) of 2,2-bis(3,4-dicarboxyphenyl)hexafluoropropane dianhydride, 25.6 g (0.06 mole) of 1,3-bis(3,4-dicarboxyphenyl)-1,1,3,3-tetramethyldisiloxane dianhydride and 32.2 g (0.1 mole) of 3,3′,4,4′-benzophenonetetracarboxylic dianhydride were added 400 ml of N-methyl-2-pyrrolidone and 520 g (0.4 mole) of 2-hydroxyethyl methacrylate as hydroxy compound having at least one ethylenic unsaturated group, and stirred at room temperature for 12 hours. To the resulting solution was added dropwise 70 g of thionyl chloride with ice-cooling over a period of 1 hour, and stirred at room temperature for 2 hours. To the solution thus obtained was added 40.0 g (0.2 mole) of 4,4′-diaminodiphenyl ether, and stirred for 8 hours.

Subsequently, 80 ml of ethanol was added and then stirred for 3 hours. The resulting solution was slowly poured into 8 liters of water, upon which a polymer was precipitated as a thread-like solid. This polymer was named PI-43.

Synthetic Examples 10 to 14

In the same manner as in Synthetic Example 9, polymers PI-44, 45 and 52 to 54 were obtained by using tetracarboxylic acid dianhydride(s), diamine(s) and a hydroxy compound having at least one ethylenically unsaturated group, according to each recipe shown in Table 1.

Examples 1 to 25

A photoinitiator of (A) and a polymerizable unsaturated compound (C) were added to each polymer (B) or solution thereof obtained in Synthetic Examples 1 to 14, and stirred and mixed therewith. Thus, there were obtained homogeneous solutions of photosensitive resin composition which were used in Examples 1 to 25.

Each of these solutions was passed through a filter, dropped on a silicon wafer, and spin coated thereon at a revolution rate of 2,000 r.p.m. for 30 minutes.

The coating film thus obtained was dried at 80°C for 10 minutes and then its thickness was measured.

Next, the surface of the coating film was covered with a pattern mask and exposed to light from a ultra-high pressure mercury lamp (8 mW/cm$^2$) for 70 seconds.

The coating film was then developed with a mixture of equal amounts of N,N-dimethylacetamide and tetrahydrofuran for 50 seconds by means of a spray type developing machine, rinsed with isopropanol for 5 seconds to leave the portion irradiated by the ultra-high pressure mercury lamp, and dried by nitrogen spraying to obtain a relief pattern.

The cured state of the relief pattern was evaluated by calculating the yield of residual film thickness according to the equation:

$$\text{Yield of residual film thickness} = \left( \begin{array}{l}\text{the thickness of}\\ \text{coating film after}\\ \text{the development}\end{array} \div \begin{array}{l}\text{the thickness of}\\ \text{coating film before}\\ \text{the development}\end{array} \right) \times 100$$

Subsequently, the coating film was heated under nitrogen at 100°C for 30 minutes, at 200°C for 30 minutes, and then at 350°C for 30 minutes to obtain a relief pattern of polyimide. The results obtained are shown in Table 2.

Each solution of photosensitive resin composition obtained in Examples 1 to 18 was coated on a glass substrate, dried, and then heated at 350°C for 1 hour. The film thus obtained was peeled from the glass substrate and film characteristics after curing were evaluated by the methods described below. The results obtained are shown in Table 2.

(1) Tensile strength

Measured by making the aforesaid film (thickness: 30 μm) into test pieces having a width of about 1 cm and a length of about 10 cm, and measuring (10 mm/min) S-S curve for five of the test pieces by means of a tensile tester.

(2) Weight loss initiation temperature

Measured in the air at a heating rate of 10°C/min by means of a differential thermobalance by using 10 mg of the aforesaid film.

In addition, each solution of photosensitive resin composition was spin coated on a silicon wafer, formed into a cured film, and subjected to adhesive properties evaluation by the so-called cross-cut test. The cross-cut test comprises cutting the cured film with a cutter knife so as to form 100 squares (1 mm□; each 1 $mm^2$), peeling off them by use of the cellophane adhesive tape prescribed in JIS K5400, and expressing the adhesive properties in terms of the number of squares peeled off per the 100 squares. The adhesive properties evaluation was carried out by counting the number of squares peeled off in the cross-cut test after treating the cured film for 100 hours by a pressure cooker test (121°C, 2 atmospheres). The results obtained are shown in Table 2.

Comparative Synthetic Examples 15 to 19

In the same manner as in Synthetic Example 9 or Referential Example 2 for Comparative Synthetic Examples 15 and 16 or Comparative Synthetic Examples 17 to 19, respectively, polymers were obtained by using a tetracarboxylic acid dianhydride, a diamine, a solvent an isocyanato compound having at least one ethylenically unsaturated group and a hydroxy group having at least one ethylenic unsaturated group in blending amounts shown in Table 1. Each of the polymers thus obtained as PI-55 to PI-59, respectively, was solidified by adding 80 ml of ethanol, followed by stirring for 3 hours and slow pouring into 8 liters of water.

Comparative Examples 1 to 14

Each of the polymers obtained in Comparative Synthetic Examples was stirred together with each photoinitiator, each polymerizable unsaturated compound and the like listed in Table 3, whereby there were obtained homogeneous solutions of photosensitive resin composition which were used in Comparative Examples 1 to 14.

In the same manner as in Examples, each solution was coated on a silicon wafer to obtain a coating film. Then, the surface of the coating film was covered with a pattern mask, and exposure, development, rinsing, etc. were conducted in the same manner as in Examples to obtain a relief pattern. The cured state of the relief was evaluated in terms of the yield of residual film thickness.

Subsequently, the coating film was heated under nitrogen at 100°C for 30 minutes, at 200°C for 30 minutes, and then at 350°C for 30 minutes, and film characteristics after curing were evaluated in the same manner as in Examples. The results obtained are shown in Table 3.

The photosensitive resin composition and the photosensitive element using the same of this invention have a high solubility, and can give a final cured film having both high heat resistance and high flexibility on the surface of a substrate. Moreover, they are good in light-transmitting properties and hence can be formed into a thick film. In addition, a thick film patterns obtained by using them have small dielectric constant and hence

are useful as interlaminar insulating materials.

Table 1

| Synthetic Example | Tetracarboxylic acid dianhydride | Diamine |
| --- | --- | --- |
| Synthetic Example 1 | 2,2-Bis(3,4-dicarboxyphenyl)-hexafluoropropane dianhydride (22.2 g)<br>1,3-Bis(3,4-dicarboxyphenyl)-1,1,3,3-tetramethyldisiloxane dianhydride (21.3 g)<br>3,3',4,4'-Benzophenonetetra-carboxylic dianhydride (32.2 g) | 4,4'-Diaminodiphenyl ether (40.0 g) |
| Synthetic Example 2 | 2,2-Bis(3,4-dicarboxyphenyl)-hexafluoropropane dianhydride (22.2 g)<br>1,3-Bis(3,4-dicarboxyphenyl)-1,1,3,3-tetramethyldisiloxane dianhydride (21.3 g)<br>3,3',4,4'-Benzophenonetetra-carboxylic dianhydride (32.2 g) | 4,4'-diaminodiphenyl ether (40.0 g) |

(to be continued)

Table 1 (cont'd)

| Isocyanate compound containing at least one ethylenic unsaturated group | Solvent | polymer |
|---|---|---|
| Isocyanatoethyl methacrylate (15.5 g) | N-Methyl-2-pyrrolidone (250 ml) | PI-27 |
| 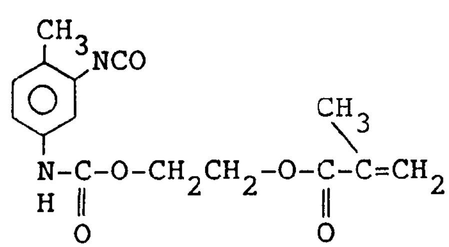 (29.0 g) | ditto (250 ml) | PI-28 |

(to be continued)

Table 1 (cont'd)

| Synthetic Example | Tetracarboxylic acid dianhydride | Diamine |
|---|---|---|
| Synthetic Example 3 | 2,2-Bis(3,4-dicarboxyphenyl)-hexafluoropropane dianhydride (22.2 g)<br>1,3-Bis(3,4-dicarboxyphenyl)-1,1,3,3-tetramethyldisiloxane dianhydride (21.3 g)<br>3,3',4,4'-Benzophenonetetracarboxylic dianhydride (32.2 g) | 2,2-Bis(4-aminophenyl)-hexafluoropropane (20.0 g) |

(to be continued)

Table 1 (cont'd)

| Isocyanate compound con-taining at least one ethylenic unsaturated group | Solvent | polymer |
|---|---|---|
| Isocyanatoethyl methacrylate (15.5 g) | N-Methyl-2-pyrrolidone (250 ml) | PI-29 |

(to be continued)

Table 1 (cont'd)

| Synthetic Example | Tetracarboxylic acid dianhydride | Diamine |
|---|---|---|
| Synthetic Example 4 | 1,3-Bis(3,4-dicarboxyphenyl)-1,1,3,3-tetramethyldisiloxane (12.8 g)<br>3,3',4,4'-Benzophenonetetra-carboxylic dianhydride (22.6 g) | 2,2-Bis(4-aminophenyl)hexa-fluoropropane (10.0 g)<br>4,4'-Diaminodiphenyl ether (14.0 g) |
| Synthetic Example 5 | 1,3-Bis(3,4-dicarboxyphenyl)-1,1,3,3-tetramethyldisiloxane dianhydride (12.8 g)<br>3,3',4,4'-Benzophenonetetra-carboxylic dianhydride (22.6 g) | 2,2-Bis[4-(4-aminophenoxy)-phenyl]hexafluoropropane (25.9 g)<br>4,4'-Diaminodiphenyl ether (10.0 g) |
| Synthetic Example 6 | 1,3-Bis(3,4-dicarboxyphenyl)-1,1,3,3-tetramethyldisiloxane dianhydride (12.8 g)<br>3,3',4,4'-Benzophenonetetra-carboxylic dianhydride (22.6 g) | 2,2-Bis(4-aminophenyl)hexa-fluoropropane (33.4 g) |

(to be continued)

Table 1 (cont'd)

| Isocyanate compound containining at least one ethylenic unsaturated group | Solvent | polymer |
|---|---|---|
| Isocyanatoethyl methacrylate (7.7 g) | ditto (250 ml) | PI-36 |
| Isocyanatoethyl methacrylate (7.7 g) | N-Methyl-2-pyrrolidone (250 ml) | PI-37 |
| Isocyanatoethyl methacrylate (7.7 g) | ditto (250 ml) | PI-38 |

(to be continued)

Table 1 (cont'd)

| Synthetic Example | Tetracarboxylic acid dianhydride | Diamine |
| --- | --- | --- |
| Synthetic Example 7 | 3,3'-Benzophenonetetracarboxylic dianhydride (64.44 g)<br>1,3-Bis(4-dicarboxyphenyl)-1,1,3,3-tetramethyldisiloxane dianhydride (85.2 g) | 4,4'-Diaminodiphenyl ether (80.1 g) |

(to be continued)

Table 1 (cont'd)

| Isocyanate compound containing at least one ethylenic unsaturated group | Solvent | polymer |
| --- | --- | --- |
| 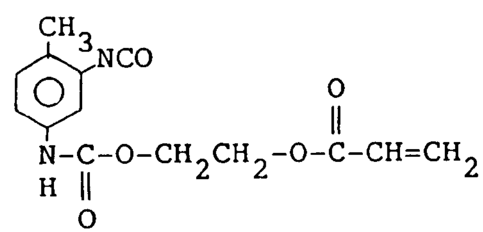 (58.0 g) | ditto (500 ml) | PI-41 |

(to be continued)

Table 1 (cont'd)

| Synthetic Example | Tetracarboxylic acid dianhydride | Diamine |
|---|---|---|
| Synthetic Example 8 | 3,3'-Benzophenonetetracarboxylic dianhydride (64.44 g)<br>1,3-Bis(4-dicarboxyphenyl)-1,1,3,3-tetramethyldisiloxane dianhydride (85.2 g) | 4,4'-Diaminodiphenyl ether (80.1 g) |
| Synthetic Example 10 | 2,2-Bis(3,4-dicarboxyphenyl)-hexafluoropropane dianhydride (20.7 g)<br>1,3-Bis(3,4-dicarboxyphenyl)-1,1,3,3-tetramethyldisiloxane dianhydride (25.6 g)<br>m-Terphenyl-3,3",4,4"-tetracarboxylic dianhydride (37.0 g) | 4,4'-Diaminodiphenyl ether (40.0 g) |

(to be continued)

Table 1 (cont'd)

| Isocyanate compound containing at least one ethylenic unsaturated group | Solvent | polymer |
|---|---|---|
| Isocyanatoethyl methacrylate (31.0 g) | N,N-Dimethylacetamide (500 ml) | PI-42 |
| 2-Hydroxyethyl methacrylate (52.0 g) | N-Methyl-2-pyrrolidone (400 ml) | PI-44 |

(to be continued)

Table 1 (cont'd)

| Synthetic Example | Tetracarboxylic acid dianhydride | Diamine |
|---|---|---|
| Synthetic Example 11 | 2,2-Bis(3,4-dicarboxyphenyl)-tetrafluoropane dianhydride (20.7 g)<br>1,3-Bis(3,4-dicarboxyphenyl)-1,1,3,3-tetramethyldisiloxane dianhydride (25.6 g)<br>3,3',4,4'-Biphenyltetra carboxylic dianhydride (29.4 g) | 2,2-Bis[4-(4-aminophenoxy)-phenyl)propane (82.1 g) |

(to be continued)

Table 1 (cont'd)

| Isocyanate compound con-taining at least one ethylenic unsaturated group | Solvent | polymer |
|---|---|---|
| 2-Hydroxyethyl methacrylate (52.0 g) | N-Methyl-2-pyrrolidone (400 ml) | PI-45 |

(to be continued)

Table 1 (cont'd)

| Synthetic Example | Tetracarboxylic acid dianhydride | Diamine |
|---|---|---|
| Synthetic Example 12 | 1,3-Bis(3,4-dicarboxyphenyl)-1,1,3,3-tetramethyldisiloxane (8.5 g)<br>3,3',4,4'-Benzophenonetetra-carboxylic dianhydride (25.7 g) | 4,4'-Diaminodiphenyl ether (14.0 g)<br>2,2-Bis(4-aminophenyl)hexa-fluoropropane (10.0 g) |
| Synthetic Example 13 | 1,3-Bis(3,4-dicarboxyphenyl)-1,1,3,3-tetramethyldisiloxane (8.5 g)<br>m-Terphenyl-3,3",4,4"-tetra-carboxylic dianhydride (29.6 g) | 4,4'-Diaminodiphenyl ether (14.0 g)<br>2,2-Bis(4-aminophenyl)-hexa-fluoropropane (10.0 g) |

(to be continued)

Table 1 (cont'd)

| Isocyanate compound containining at least one ethylenic unsaturated group | Solvent | polymer |
|---|---|---|
| 2-Hydroxyethyl methacrylate (26.0 g) | ditto (200 ml) | PI-52 |
| 2-Hydroxyethyl methacrylate (26.0 g) | ditto (200 ml) | PI-53 |

(to be continued)

Table 1 (cont'd)

| Synthetic Example | Tetracarboxylic acid dianhydride | Diamine |
|---|---|---|
| Synthetic Example 14 | 1,3-Bis(3,4-dicarboxyphenyl)-1,1,3,3-tetramethyldisiloxane dianhydride (8.5 g)<br>3,3',4,4'-Benzophenonetetracarboxylic dianhydride (25.7 g) | 4,4'-Diaminodiphenyl ether (10.0 g)<br>2,2-Bis[4-(4-aminophenoxy)-phenyl)hexafluoropropane (25.9 g) |

(to be continued)

Table 1 (cont'd)

| Isocyanate compound containing at least one ethylenic unsaturated group | Solvent | polymer |
|---|---|---|
| 2-Hydroxyethyl methacrylate (26.0 g) | N-methyl-2-pyrrolidone (200 ml) | PI-54 |

(to be continued)

Table 1 (cont'd)

| Comp. Synthetic Example | Tetracarboxylic acid dianhydride | Diamine |
|---|---|---|
| Comp. Synthetic Example 155 | Pyromellitic dianhydride (21.8 g) | 4,4'-Diaminodiphenyl ether (20.0 g) |
| Comp. Synthetic Example 156 | 3,3',4,4'-Benzophenonetetra-carboxylic dianhydride (32.2 g) | 4,4'-Diaminodiphenyl ether (20.0 g) |
| Comp. Synthetic Example 157 | Pyromellitic dianhydride (14.0 g) | p-Phenylenediamine (10.8 g) |
| Comp. Synthetic Example 158 | 3,3',4,4'-Benzophenonetetra-carboxylic dianhydride (32.2 g) | 4,4'-Diaminodiphenyl ether (20.0 g) |
| Comp. Synthetic Example 159 | 3,3',4,4'-Benzophenonetetra-carboxylic dianhydride (128.88 g) | 4,4'-Diaminodiphenyl ether (80.10 g) |

(to be continued)

Table 1 (cont'd)

| Hydroxy compound containing at least one ethylenic unsaturated group/isocyanate compound containing at least one ethylenic unsaturated group | Solvent | polymer |
|---|---|---|
| 2-Hydroxyethyl methacrylate (26.0 g) | N-Methyl-2-pyrroldione (202 ml) | PI-55 |
| 2-Hydroxyethyl methacrylate (26.0 g) | ditto (202 ml) | PI-56 |
| Isocyanatoethyl methacrylate (15.5 g) | ditto (250 ml) | PI-57 |
| Isocyanatoethyl methacrylate (15.5 g) | ditto (250 ml) | PI-58 |
| Isocyanatoethyl methacrylate (31.0 g) | N,N-dimethyl-acetamide (500 ml) | PI-59 |

Table 2

| Example | Polymer | Photoinitiator | Assistant of photoinitiator | Polymerizable unsaturated compound | Solvent | Thickness of coating film before development | Yield of residual film thickness | Tensile strength | Weight loss initiation temperature |
|---|---|---|---|---|---|---|---|---|---|
| Example 1 | PI-43 (10 g) | 2,4-Diethylthioxyanthone (0.3 g) | Ethyl N,N-diethylaminobenzoate (0.4 g) | Tetraethylene glycol diacrylate (1.6 g) | N-Methyl-2-pyrrolidone (23.5 g) | 30 μm | 84% | 6.0 kgf/mm2 | 410°C |
| Example 2 | PI-43 (10 g) | ditto (0.3 g) | ditto (0.4 g) | 1,6-Hexanediol diacrylate (1.5 g) | ditto (24 g) | 28 μm | 85% | 5.2 kgf/mm2 | 400°C |
| Example 3 | PI-44 (10 g) | ditto (0.3 g) | ditto (0.4 g) | — | ditto (25 g) | 31 μm | 85% | 6.2 kgf/mm2 | 415°C |

- Cont'd -

Table 2 (Cont'd)

| | | | | | | | | |
|---|---|---|---|---|---|---|---|---|
| Example 4 | PI-44 (10 g) | ditto (0.3 g) / ditto (0.4 g) | Tetraethylene glycol dimethacrylate (1.7 g) | ditto (25 g) | 29 µm | 83% | 5.7 kgf/mm2 | 398°C |
| Example 5 | PI-45 (10 g) | 2,6-Bis(p-diethylaminobenzylidene-4-methyl-4-azacyclohexanone (0.1 g) / N-(p-cyanophenyl)-glycine (0.6 g) | Tetraethylene glycol diacrylate (1.6 g) | ditto (24 g) | 28 µm | 85% | 5.6 kgf/mm2 | 395°C |
| Example 6 | PI-27 (10 g) | Benzophenone (0.1 g) / Michler's ketone (0.1 g) | 1,6-Hexanediol diacrylate (1.5 g) | ditto (24 g) | 30 µm | 88% | 5.5 kgf/mm2 | 395°C |

- Cont'd -

Table 2 (Cont'd)

| | | | | | | | | | |
|---|---|---|---|---|---|---|---|---|---|
| Example 7 | PI-27 (10 g) | 2,4-Diethylthioxanthone (0.3 g) / Isoamyl N,N-diethylaminobenzoate (0.4 g) | Tetraethylene glycol diacrylate (1.6 g) | ditto (24 g) | 29 µm | 85% | 6.0 kgf/mm$^2$ | 405°C | |
| Example 8 | PI-28 (10 g) | 2,4-Diethylthioxanthone (0.3 g) / Isoamyl N,N-diethylaminobenzoate (0.4 g) | Tetraethylene glycol diacrylate (1.6 g) | N-Methyl-2-pyrrolidone (25 g) | 31 µm | 86% | 6.1 kgf/mm$^2$ | 410°C | |
| Example 9 | PI-29 (10 g) | ditto (0.3 g) / ditto (0.4 g) | Tetraethylene glycol diacrylate (1.7 g) | ditto (25 g) | 30 µm | 82% | 6.5 kgf/mm$^2$ | 400°C | |
| | | | | | | | | | |

- Cont'd -

Table 2 (Cont'd)

| | | | | | | | | |
|---|---|---|---|---|---|---|---|---|
| Example 10 | PI-52 (10 g) | 2,6-Bis(p-diethylaminobenzylidene)-4-methyl-4-azacyclohexanone (0.1 g) / N-(p-cyanophenylglycine (0.6 g) | Tetraethylene glycol diacrylate (1.6 g) | ditto (24 g) | 34 µm | 80% | 5.5 $kgf/mm^2$ | 398°C |

- Cont'd -

Table 2 (Cont'd)

| | | | | | | | | | | |
|---|---|---|---|---|---|---|---|---|---|---|
| Example 11 | PI-53 (10 g) | ditto (0.1 g) | ditto (0.6 g) | Tetraethylene glycol diacrylate (1.7 g) | ditto (25 g) | 31 µm | 85% | 5.6 $kgf/mm^2$ | 395°C |
| Example 12 | PI-54 (10 g) | 2,4-Diethylthioxanthone (0.3 g) | Ethyl N,N-diethylaminobenzoate (0.5 g) | Tetraethylene glycol dimethacrylate (1.5 g) | N-Methyl-2-pyrrolidone (25 g) | 34 µm | 85% | 5.9 $kgf/mm^2$ | 400°C |

- Cont'd -

Table 2 (Cont'd)

| | | | | | | | | | |
|---|---|---|---|---|---|---|---|---|---|
| Example 13 | PI-36 (10 g) | Benzophenone (0.4 g) / Michler's ketone (0.1 g) | Tetraethylene glycol dimethacrylate (1.6 g) | ditto (24 g) | 30 μm | 86% | 5.6 kgf/mm2 | 398°C |
| Example 14 | PI-36 (10 g) | 2,6-Bis(p-diethylaminobenzylidene)-4-methyl-4-azacyclohexanone (0.1 g) / N-(p-cyanophenyl)-glycine (0.6 g) | 1,6-Hexanediol diacrylate (1.5 g) | ditto (24 g) | 30 μm | 84% | 5.4 kgf/mm2 | 394°C |
| Example 15 | PI-37 (10 g) | ditto (0.1 g) / ditto (0.6 g) | ditto (1.5 g) | ditto (24 g) | 30 μm | 85% | 6.0 kgf/mm2 | 403°C |
| Example 16 | PI-37 (10 g) | ditto (0.1 g) / ditto (0.6 g) | Tetraethylene glycol diacrylate (1.6 g) | ditto (24 g) | 28 μm | 87% | 6.2 kgf/mm2 | 405°C |

- Cont'd -

Table 2 (Cont'd)

| | | | | | | | | | | |
|---|---|---|---|---|---|---|---|---|---|---|
| Example 17 | PI-38 (10 g) | ditto (0.1 g) | ditto (0.6 g) | ditto (1.5 g) | ditto (24 g) | 30 µm | 85% | 6.0 kgf/mm2 | 400°C |

- Cont'd -

Table 2 (Cont'd)

| | | | | | | | | | |
|---|---|---|---|---|---|---|---|---|---|
| Example 18 | PI-41 (100) | 2,6-Bis(p-diethylaminobenzylidene)-4-methyl-4-azacyclohexanone (0.18) | N-(p-Cyanophenyl)-glycine (1.8) | Ethylene glycol dimethacrylate (7.1) | 28 μm | 82% | 95 sec | 6.0 kgf/mm2 | 390°C |
| Example 19 | PI-41 (100) | 2,6-Bis(p-diethylaminobenzylidene)-4-methyl-4-azacyclohexanone (0.18) | N-(p-cyclorophenyl)-glycine (1.8) | Diethylene glycol dimethacrylate (7.1) | 28 μm | 80% | 95 sec | 6.0 kgf/mm2 | 392°C |
| Example 20 | PI-41 (100) | 2,6-Bis(p-diethylaminobenzylidene)-4-methyl-4-azacyclohexanone (0.18) | N-(p-cyclorophenyl)-glycine (1.8) | 2,2-Bis-(4-acryloxypentaethoxyphenyl)-propane (7.1) | 29 μm | 83% | 95 sec | 6.2 kgf/mm2 | 400°C |

(the unit of the figures in parentheses: gram)

- Cont'd -

Table 2 (Cont'd)

| | | | | | | | | | |
|---|---|---|---|---|---|---|---|---|---|
| Example 21 | PI-41 (100) | 2,6-Bis(p-dimethylaminobenzylidene)-cyclopentanone (0.18) | N-Ethyl-N-(p-cyanophenyl)-glycine (1.8) | Tris(2-acryloylethyl) isocyanurate (7.1) | 27 µm | 80% | 90 sec | 6.3 kgf/mm2 | 405°C |
| Example 22 | PI-42 (100) | 2,6-Bis(p-dimethylaminobenzylidene)-cyclopentanone (0.18) | N-(p-cyanophenyl)-glycine (1.8) | Ethylene glycol dimethacrylate (7.1) | 29 µm | 84% | 100 sec | 6.1 kgf/mm2 | 395°C |
| Example 23 | PI-42 (100) | 2,6-Bis(p-dimethylaminobenzylidene)-4-phenylcyclohexanone (0.18) | N-Ethyl-N-(p-chlorophenyl)-glycine (1.8) | Diethylene glycol dimethacrylate (7.1) | 28 µm | 85% | 90 sec | 6.2 kgf/mm2 | 398°C |
| Example 24 | PI-42 (100) | 2,6-Bis(p-diethylaminobenzylidene)-4-methylazacyclohexanone (0.18) | N-(p-cyanophenyl)-glycine (1.8) | Tris(2-acryloylethyl) isocyanurate (7.1) | 28 µm | 86% | 95 sec | 6.5 kgf/mm2 | 410°C |

(the unit of the figures in parentheses: gram)

- Cont'd -

Table 2 (Cont'd)

| | | | | | | | | |
|---|---|---|---|---|---|---|---|---|
| Example 25 | PI-42 (100) | 2,6-Bis(p-dimethylaminobenzylidene)-cyclopentanone (0.18) / N-Ethyl-N-(p-chlorophenyl)-glycine (1.8) | 2,2-Bis-(4-acryloxypentaethoxyphenyl)-propane (7.1) | 30 µm | 85% | 105 sec | 6.4 kgf/mm2 | 406°C |

(the unit of the figures in parentheses: gram)

Table 3

| Comp. Example | Polymer | Photoinitiator / Assistant of photoinitiator | Polymerizable unsaturated compound |
|---|---|---|---|
| Comp. Example 1 | PI-59 (100g) | 2,4-Diethylthio-xanthone (0.6g) / Ethyl p-dimethylamino-benzoate (0.9g) | A-BPE-10 (4.5g) |
| Comp. Example 2 | PI-59 (100g) | ditto (0.6g) / ditto (0.9g) | - |
| Comp. Example 3 | PI-59 (100g) | 2,6-Bis(p-diethylamino-benzylidene)-4-methyl-4-azacyclohexanone (0.15g) / N-Phenylglycine (1.5g) | Ethylene glycol diacrylate (4.5g) |
| Comp. Example 4 | PI-59 (100g) | 2,4-Diethylthio-xanthone (0.6g) / Ethyl p-dimethylamino-benzoate (0.9g) | Ethylene glycol diacrylate (4.5g) |
| Comp. Example 5 | PI-59 (100g) | 2,6-Bis(p-diethylamino benzylidene)-4-methyl-4-azacyclohexanone (0.15g) / N-(p-Cyano-phenyl)glycine (1.5g) | - |
| Comp. Example 6 | PI-59 (100g) | ditto (0.15g) / ditto (1.5g) | Ethylene glycol diacrylate (4.5g) |

(to be continued)

Table 3 (Cont'd)

| Thickness of coating film before development | Yield of residual film thickness | Tensile strength | Weight loss initiation temperature |
|---|---|---|---|
| 32 µm | 48% | 8.1kgf/$mm^2$ | 405°C |
| 30 µm | 38% | 7.8kgf/$mm^2$ | 413°C |
| 33 µm | 50% | 8.0kgf/$mm^2$ | 410°C |
| 31 µm | 56% | 7.9kgf/$mm^2$ | 410°C |
| 32 µm | 48% | 7.7kgf/$mm^2$ | 408°C |
| 33 µm | 50% | 8.0kgf/$mm^2$ | 410°C |

Note:

A-PBE-10: 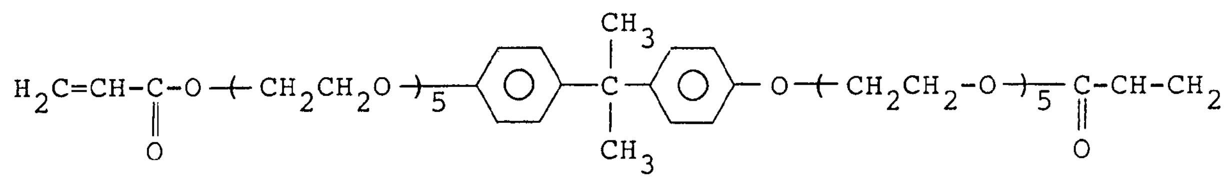

Table 3 (Cont'd)

| Comp. Example | Polymer | Photoinitiator / Assistant of photoinitiator | Polymerizable unsaturated compound |
|---|---|---|---|
| Comp. Example 8 | PI-55 (10g) | 2,6-Bis(p-diethylaminobenzylidene)-4-methyl-4-azacyclohexanone (0.1g) / N-(p-Cyanophenyl)glycine (0.6g) | Tetraethylene glycol dimethacrylate (1.5g) |
| Comp. Example 9 | PI-56 (10g) | ditto (0.1g) / ditto (0.6g) | ditto (1.5g) |
| Comp. Example 10 | PI-57 (10g) | 2,4-Diethylthioxanthone (0.3g) / Ethyl N,N-diethylaminobenzoate (0.5g) | 1,6-Hexanediol diacrylate (1.6g) |
| Comp. Example 11 | PI-58 (10g) | ditto (0.3g) / ditto (0.5g) | ditto (1.6g) |

(to be continued)

Table 3 (Cont'd)

| Solvent | Thickness of coating film before development | Yield of residual film thickness after development | Tensile strength | Weight loss initiation temperature |
|---|---|---|---|---|
| N-Methyl-2-pyrrolidone (34g) | 30 μm | 55% | 7.0 $kgf/mm^2$ | 415°C |
| ditto (35g) | 28 μm | 52% | 7.5 $kgf/mm^2$ | 409°C |
| ditto (36g) | 28 μm | 48% | 6.8 $kgf/mm^2$ | 410°C |
| ditto (35g) | 30 μm | 45% | 7.8 $kgf/mm^2$ | 420°C |

(to be continued)

Table 3 (Cont'd)

| Comp. Example | Polymer | Photoinitiator / Assistant of photoinitiator | Polymerizable unsaturated compound |
|---|---|---|---|
| Comp. Example 12 | PI-59 (100) | 2,6-Bis(p-dimethylaminobenzylidene)-4-methyl-4-azacyclohexanone (0.18)<br>N-Ethyl-N-(p-chlorophenyl)glycine (1.8) | Ethylene glycol dimethacrylate (7.1) |
| Comp. Example 13 | PI-59 (100) | 2,6-Bis(p-diethylaminobenzylidene)-4-methyl-4-azacyclohexanone (0.18)<br>N-Ethyl-N-(p-chlorophenyl)glycine (1.8) | Diethylene glycol dimethacrylate (7.1) |
| Comp. Example 14 | PI-59 (100) | 2,6-Bis(p-dimethylaminobenzylidene)-cyclopentanone (0.18)<br>N-Ethyl-N-(p-chlorophenyl)glycine (1.8) | 2,2-Bis(4-acryloxypenta-ethoxyphenyl)-propane (7.1) |

(to be continued)

(the unit of the figures in parentheses: gram)

Table 3 (Cont'd)

| Thickness of coating film before development | Yield of residual film thickness | Development time | Tensile strength | Weight loss initiation temperature |
|---|---|---|---|---|
| 28 µm | 45% | 215 sec | 7.8 $kgf/mm^2$ | 405°C |
| 29 µm | 43% | 210 sec | 7.5 $kgf/mm^2$ | 400°C |
| 28 µm | 48% | 215 sec | 7.6 $kgf/mm^2$ | 410°C |

## Claims

1. A negative-type photosensitive resin composition comprising (A) a photoinitiator, (B) a polymer obtainable by reacting an isocyanate compound having at least one ethylenically unsaturated group with a polymer containing a repeating unit of formula (1)

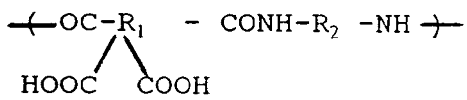

(1)

wherein $R_1$ is a silicon-containing tetravalent organic group of formula (VI)

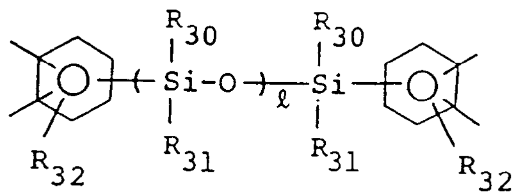

(VI)

in which $R_{30}$ and $R_{31}$ are the same or different and each is a monovalent hydrocarbon group; $R_{32}$ is hydrogen or a monovalent organic group; and $\ell$ is zero or an integer of 1 to 20, and $R_2$ is a divalent organic group, and (C) one or more polymerisable unsaturated compounds.

2. A composition according to claim 1 wherein in formula (1), $R^2$ is a divalent aromatic group or a siloxane group-containing divalent organic group.

3. A composition according to claim 1 or claim 2 wherein, in formula (1), at least one of $R_1$ and $R_2$ contains at least one fluorine atom.

4. A composition according to any one of claims 1 to 3 comprising a polymer (B) obtainable by reacting a compound of formula (III) and/or a compound of formula (IV) with a compound of formula (V) :

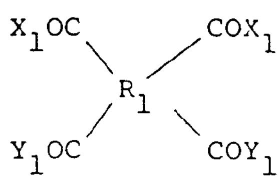

(III)

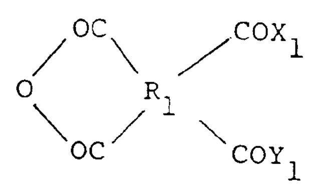

(IV)

$H_2N\text{-}R_2\text{-}NH_2$ (V)

wherein $R_1$ and $R_2$ are as defined in relation to formula (1), $X_1$ is halogen or hydroxyl, and $Y_1$ is a monovalent group obtainable by reaction of a corresponding carboxylic acid group with an isocyanate compound containing an ethylenically unsaturated group.

5. A composition according to any one of claims 1 to 4 wherein, in formula (1), $R_2$ is a silicon atom-containing divalent organic group of formula (VII)

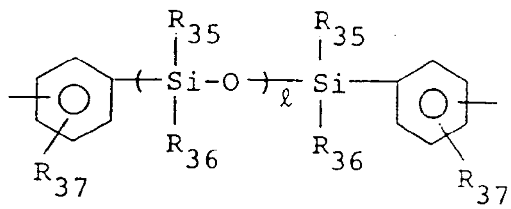

(VII)

wherein $R_{35}$ and $R_{36}$ are the same or different and each is a monovalent hydrocarbon group $R_{37}$, is hydrogen or a monovalent organic group; and $\ell$ is zero or an integer of 1 to 20.

6. A composition according to any one of claims 1 to 4 wherein, in formula (1), $R_2$ is a fluorine atom-containing divalent organic group of formula (IX)

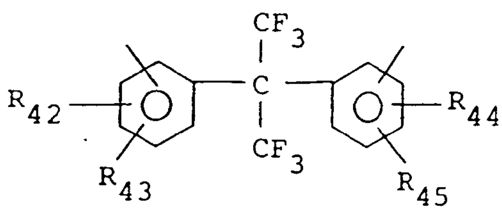

(IX)

in which $R_{42}$, $R_{43}$, $R_{44}$ and $R_{45}$ are the same or different and each is hydrogen or alkyl or $R_2$ is a fluorine atom-containing divalent organic group of formula (X)

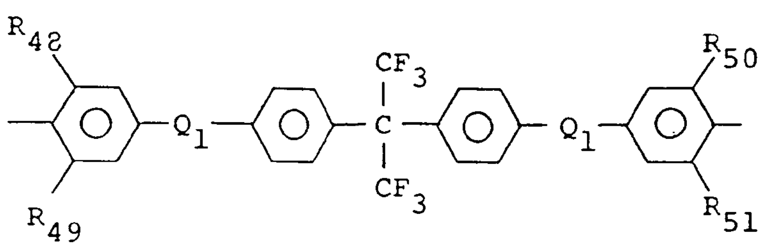

(X)

in which $Q_1$ is oxygen or sulphur and $R_{48}$, $R_{49}$, $R_{50}$ and $R_{51}$ are the same or different and each is hydrogen or alkyl.

7. A composition according to claim 1 wherein the polymer (B) is obtainable by reacting a polymer containing a repeating unit of formula (XI) and a repeating unit of formula (XII)

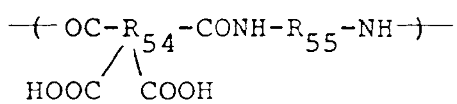

(XI)

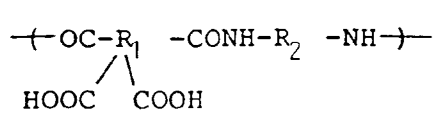

(XII)

wherein $R_{54}$ is a tetravalent aromatic group which is the same as or different from $R_1$ and $R_{55}$ is a divalent organic group which is the same as or different from $R_2$ with an isocyanate compound of formula (XIV)

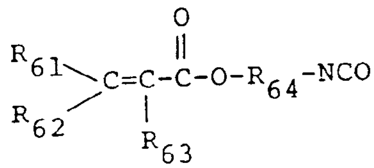

(XIV)

wherein $R_{61}$, $R_{62}$ and $R_{63}$ are the same or different and each is hydrogen or methyl and $R_{64}$ is a divalent hydrocarbon group or with an isocyanate compound of formula (XV)

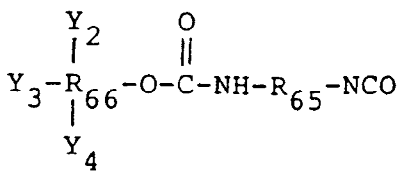

(XV)

wherein $R_{65}$ is a divalent hydrocarbon group, $R_{66}$ is a tetravalent organic group, and $Y_2$, $Y_3$ and $Y_4$ are the same or different and each is hydrogen or a monovalent organic group having an ethylenically unsaturated group, at least one of $Y_2$, $Y_3$ and $Y_4$ being a monovalent organic group having an ethylenically unsaturated group.

8. A composition according to claim 1 wherein the polymer (B) is obtainable by reacting a polymer containing a repeating unit of formula (XVI) and a repeating unit of formula (XVII)

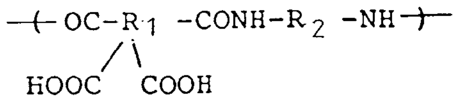

(XVI)

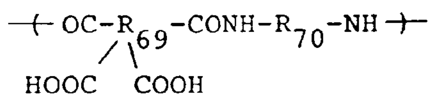

(XVII)

wherein $R_{69}$ is a tetravalent organic group and is the same or different from $R_1$ and $R_{70}$ is a silicon atom-containing divalent organic group of formula (XVIII)

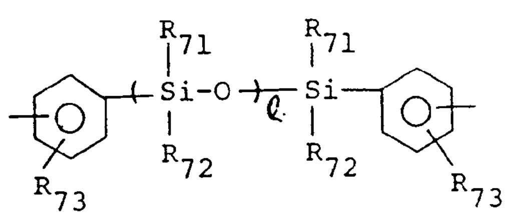

(XVIII)

wherein $R_{71}$ and $R_{72}$ are the same or different and each is a monovalent hydrocarbon group, $R_{73}$ is hydrogen or a monovalent organic group and $\ell$ is zero or an integer of 1 to 20, with an isocyanate compound of formula (XIV) or (XV) as defined in claim 7.

9. A photosensitive element comprising a base material and a photosensitive resin composition according to any one of claims 1 to 8 laminated thereon.

## Patentansprüche

1. Lichtempfindliche Harzmasse vom Negativ-Typ, enthaltend (A) einen Photoinitiator, (B) ein Polymeres,

das durch Umsetzen einer Isocyanatverbindung mit mindestens einer ethylenisch ungesättigten Gruppe mit einem Polymeren, das eine repetierende Einheit der Formel (1)

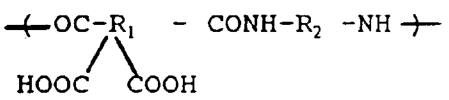

(1)

enthält, worin $R_1$ für eine Silicium-enthaltende vierwertige organische Gruppe der Formel (VI)

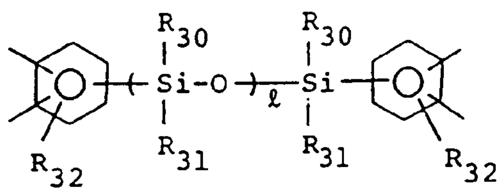

(VI)

steht, in der $R_{30}$ und $R_{31}$ gleich oder verschieden sind und jeweils eine einwertige Kohlenwasserstoffgruppe bedeuten; $R_{32}$ ein Wasserstoffatom oder eine einwertige organische Gruppe bedeutet und l 0 oder eine ganze Zahl von 1 bis 20 ist, und $R_2$ eine zweiwertige organische Gruppe ist, erhältlich ist, und (C) eine oder mehrere polymerisierbare ungesättigte Verbindungen.

2. Masse nach Anspruch 1, dadurch **gekennzeichnet,** daß in Formel (1) $R_2$ eine zweiwertige aromatische Gruppe oder eine Siloxangruppe-enthaltende zweiwertige organische Gruppe ist.

3. Masse nach Anspruch 1 oder 2, dadurch **gekennzeichnet,** daß in Formel (1) mindestens eine Gruppe von $R_1$ und $R_2$ mindestens ein Fluoratom enthält.

4. Masse nach einem der Ansprüche 1 bis 3, dadurch **gekennzeichnet,** daß sie ein Polymeres (B) enthält, das durch Umsetzen einer Verbindung der Formel (III) und/oder einer Verbindung der Formel (IV) mit einer Verbindung der Formel (V)

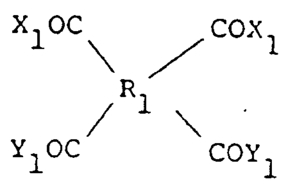

(III)

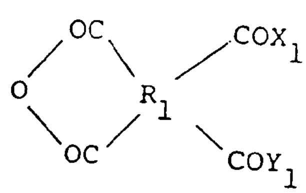

(IV)

$$H_2N\text{-}R_2\text{-}NH_2 \qquad (V)$$

erhältlich ist, worin $R_1$ und $R_2$ so wie im Zusammenhang mit Formel (1) definiert sind, $X_1$ für Halogen oder für Hydroxyl steht und $Y_1$ eine einwertige Gruppe ist, die durch die Reaktion einer entsprechenden Carbonsäuregruppe mit einer Isocyanatverbindung, die eine ethylenisch ungesättigte Gruppe enthält, erhältlich ist.

5. Masse nach einem der Ansprüche 1 bis 4, dadurch **gekennzeichnet,** daß in Formel (1) $R_2$ eine Siliciumatom-enthaltende zweiwertige organische Gruppe der Formel (VII)

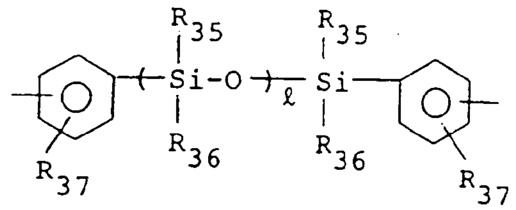

(VII)

ist, worin $R_{35}$ und $R_{36}$ gleich oder verschieden sind und jeweils für eine einwertige Kohlenwasserstoffgruppe stehen, $R_{37}$ für ein Wasserstoffatom oder eine einwertige organische Gruppe steht und l 0 oder eine ganze Zahl von 1 bis 20 bedeutet.

6. Masse nach einem der Ansprüche 1 bis 4, dadurch **gekennzeichnet,** daß in Formel (1) $R_2$ eine Fluoratom-enthaltende zweiwertige organische Gruppe der Formel (IX)

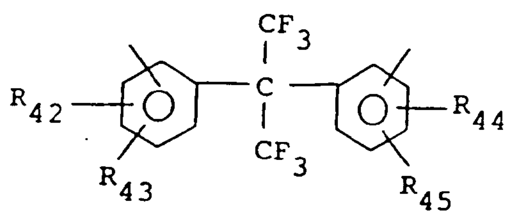

(IX)

ist, in der $R_{42}$, $R_{43}$, $R_{44}$ und $R_{45}$ gleich oder verschieden sind und jeweils für ein Wasserstoffatom oder für Alkyl stehen, oder $R_2$ eine Fluoratom-enthaltende zweiwertige organische Gruppe der Formel (X) ist,

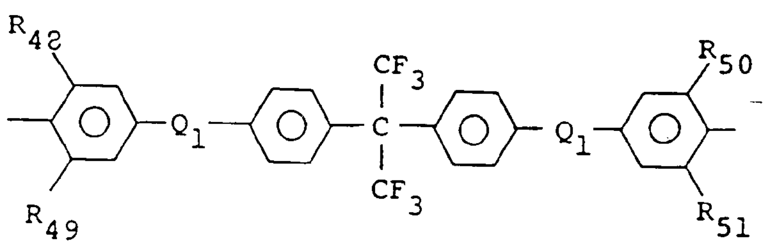

(X)

worin $Q_1$ für Sauerstoff oder Schwefel steht und $R_{48}$, $R_{49}$, $R_{50}$ und $R_{51}$ gleich oder verschieden sind und jeweils für ein Wasserstoffatom oder für Alkyl stehen.

7. Masse nach Anspruch 1, dadurch **gekennzeichnet,** daß das Polymere (B) erhältlich ist durch Umsetzen eines Polymeren, das eine repetierende Einheit der Formel (XI) und eine repetierende Einheit der Formel (XII)

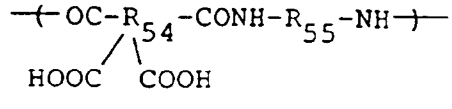

(XI)

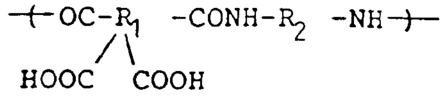

(XII)

enthält, worin $R_{54}$ eine vierwertige aromatische Gruppe ist, die dieselbe wie $R_1$ oder davon verschieden ist, und $R_{55}$ eine zweiwertige organische Gruppe ist, die dieselbe wie $R_2$ oder davon verschieden ist, mit einer Isocyanatverbindung der Formel (XIV)

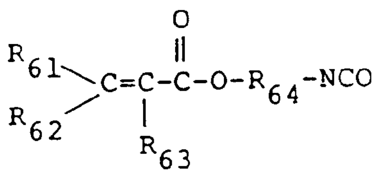

(XIV)

worin $R_{61}$, $R_{62}$ und $R_{63}$ gleich oder verschieden sind, und jeweils für ein Wasserstoffatom oder für Methyl stehen und $R_{64}$ für eine zweiwertige Kohlenwasserstoffgruppe steht, oder mit einer Isocyanatverbindung der Formel (XV)

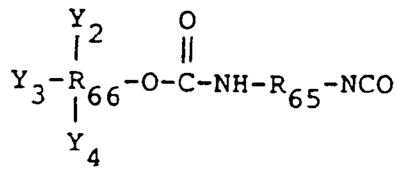

(XV)

worin $R_{65}$ für eine zweiwertige Kohlenwasserstoffgruppe steht, $R_{66}$ für eine vierwertige organische Gruppe steht und $Y_2$, $Y_3$ und $Y_4$ gleich oder verschieden sind und jeweils für ein Wasserstoffatom oder eine einwertige organische Gruppe mit einer ethylenisch ungesättigten Gruppe stehen, wobei mindestens eine von $Y_2$, $Y_3$ und $Y_4$ eine einwertige organische Gruppe mit einer ethylenisch ungesättigten Gruppe bedeutet.

8. Masse nach Anspruch 1, dadurch **gekennzeichnet,** daß das Polymere (B) erhältlich ist durch Umsetzen eines Polymeren, das eine repetierende Einheit der Formel (XVI) und eine repetierende Einheit der Formel (XVII)

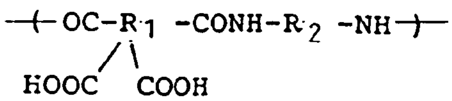

(XVI)

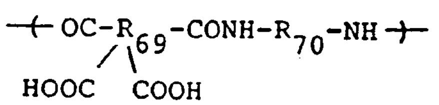

(XVII)

enthält, worin $R_{69}$ für eine vierwertige organische Gruppe steht und die gleiche Gruppe wie $R_1$ oder davon verschieden ist und $R_{70}$ für eine Siliciumatom-enthaltende zweiwertige organische Gruppe der Formel (XVIII) steht,

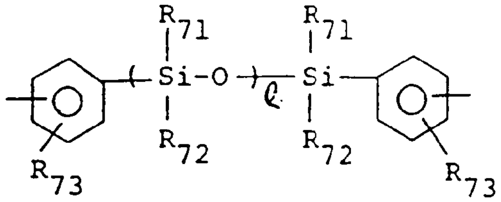

(XVIII)

worin $R_{71}$ und $R_{72}$ gleich oder verschieden sind und jeweils für eine einwertige Kohlenwasserstoffgruppe stehen, $R_{73}$ für ein Wasserstoffatom oder eine einwertige organische Gruppe steht und l 0 oder eine ganze Zahl von 1 bis 20 bedeutet, mit einer Isocyanatverbindung der Formel (XIV) oder (XV) wie in Anspruch 7 definiert.

**9.** Lichtempfindliches Element, umfassend ein Basismaterial und eine darauf laminierte lichtempfindliche Harzmasse nach einem der Ansprüche 1 bis 8.

## Revendications

**1.** Composition de résine photosensible du type négatif, comprenant (A) un photoamorceur, (B) un polymère qui peut être obtenu par réaction d'un composé isocyanate comportant au moins un groupe à insaturation éthylénique avec un polymère contenant des motifs répétés de formule (1) :

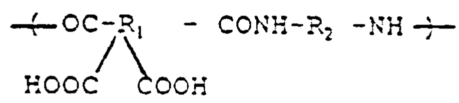

(1)

dans laquelle $R_1$ représente un groupe organique tétravalent contenant du silicium, de formule

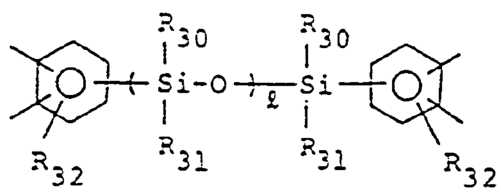

(VI)

dans laquelle $R_{30}$ et $R_{31}$ sont identiques ou différents et représentent chacun un groupe hydrocarboné monovalent, $R_{32}$ représente un atome d'hydrogène ou un groupe organique monovalent, et $\ell$ représente 0 ou un nombre entier valant de 1 à 20,
et $R_2$ représente un groupe organique divalent,
et (C) un ou plusieurs composés insaturés polymérisables.

**2.** Composition conforme à la revendication 1, dans laquelle, dans la formule (1), $R_2$ représente un groupe aromatique divalent ou un groupe organique divalent comportant un groupe siloxane.

**3.** Composition conforme à la revendication 1 ou 2, dans laquelle, dans la formule (1), au moins l'un des groupes $R_1$ et $R_2$ comporte au moins un atome de fluor.

**4.** Composition conforme à l'une des revendications 1 à 3, comprenant un polymère (B) qui peut être obtenu par réaction d'un composé de formule (III) et/ou d'un composé de formule (IV) avec un composé de formule (V) :

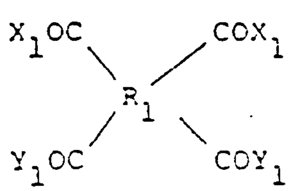

(III)

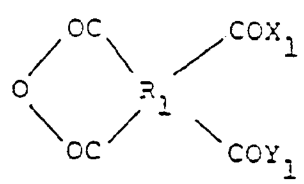

(IV)

$H_2N-R_2-NH_2$ (V)

formules dans lesquelles $R_1$ et $R_2$ ont les mêmes définitions que celles indiquées à propos de la formule (1), $X_1$ représente un atome d'halogène ou un groupe hydroxyle, et $Y_1$ représente un groupe monovalent qui peut être formé par réaction d'un groupe carboxyle correspondant avec un composé isocyanate comportant un groupe à insaturation éthylénique.

5. Composition conforme à l'une des revendications 1 à 4, dans laquelle, dans la formule (1), $R_2$ représente un groupe organique divalent contenant du silicium, de formule (VII)

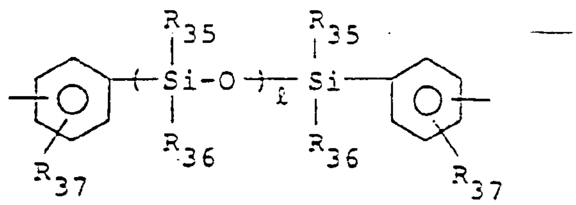

(VII)

dans laquelle $R_{35}$ et $R_{36}$ sont identiques ou différents et représentent chacun un groupe hydrocarboné monovalent, $R_{37}$ représente un atome d'hydrogène ou un groupe organique monovalent, et $\ell$ représente 0 ou un nombre entier valant de 1 à 20.

6. Composition conforme à l'une des revendications 1 à 4, dans laquelle, dans la formule (1), $R_2$ représente un groupe organique divalent contenant des atomes de fluor, de formule (IX) :

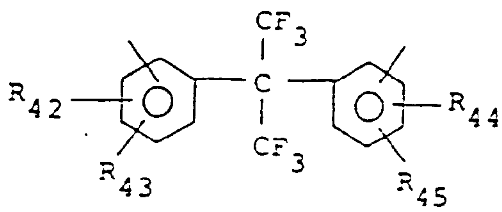

(IX)

dans laquelle $R_{42}$, $R_{43}$, $R_{44}$ et $R_{45}$ sont identiques ou différents et représentent chacun un atome d'hydrogène ou un groupe alkyle,
ou bien $R_2$ représente un groupe organique divalent contenant des atomes de fluor, de formule (X) :

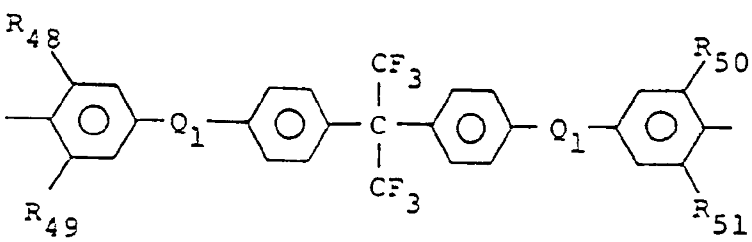

(X)

dans laquelle $Q_1$ représente un atome d'oxygène ou de soufre et $R_{48}$, $R_{49}$, $R_{50}$ et $R_{51}$ sont identiques ou différents et représentent chacun un atome d'hydrogène ou un groupe alkyle.

7. Composition conforme à la revendication 1, dans laquelle le polymère (B) peut être obtenu par réaction d'un polymère comportant des motifs répétés de formule (XI) et des motifs répétés de formule (XII)

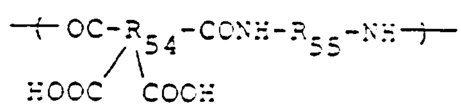

(XI)

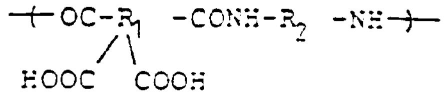

(XII)

dans lesquelles $R_{54}$ représente un groupe aromatique tétravalent identique à $R_1$ ou différent de celui-ci, et $R_{55}$ représente un groupe organique divalent identique à $R_2$ ou différent de celui-ci, avec un composé isocyanate de formule (XIV)

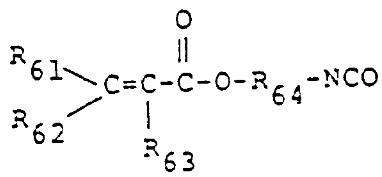

(XIV)

dans laquelle $R_{51}$, $R_{52}$ et $R_{63}$ sont identiques ou différents et représentent chacun un atome d'hydrogène ou un groupe méthyle, et $R_{64}$ représente un groupe hydrocarboné divalent, ou avec un composé isocyanate de formule (XV)

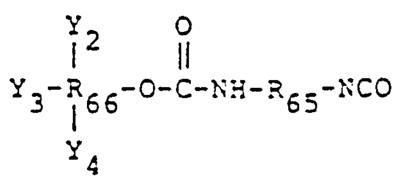

(XV)

dans laquelle $R_{65}$ représente un groupe hydrocarboné divalent, $R_{56}$ représente un groupe organique tétravalent, et $Y_2$, $Y_3$ et $Y_4$ sont identiques ou différents et représentent chacun un atome d'hydrogène ou un groupe organique monovalent comportant un groupe à insaturation éthylénique, au moins l'un des symboles $Y_2$, $Y_3$ et $Y_4$ représentant un groupe organique monovalent comportant un groupe à insaturation éthylénique.

**8.** Composition conforme à la revendication 1, dans laquelle le polymère (B) peut être obtenu par réaction d'un polymère comportant des motifs répétés de formule (XVI) et des motifs répétés de formule (XVII)

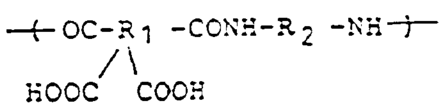

(XVI)

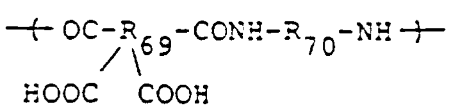

(XVII)

dans lesquelles $R_{59}$ représente un groupe organique tétravalent identique à $R_1$ ou différent de celui-ci, et $R_{70}$ représente un groupe organique divalent contenant du silicium, de formule (XVIII)

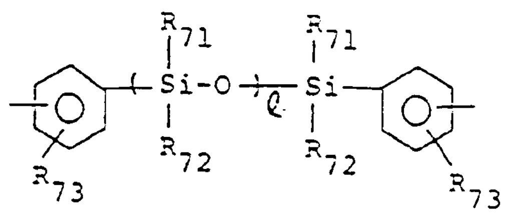

(XVIII)

dans laquelle $R_{71}$ et $R_{72}$ sont identiques ou différents et représentent chacun un groupe hydrocarboné monovalent, $R_{73}$ représente un atome d'hydrogène ou un groupe organique monovalent, et $\ell$ représente 0 ou un nombre entier valant de 1 à 20,
avec un composé isocyanate de formule (XIV) ou (XV), défini dans la revendication 7.

**9.** Elément photosensible comportant un matériau de support et une composition de résine photosensible, conforme à l'une des revendications 1 à 8, que l'on a étalée dessus.